# EUROPEAN PATENT SPECIFICATION

(11) **EP 1 621 337 B1**
(45) Date of publication and mention of the grant of the patent: **22.03.2017**
(21) Application number: 05012745.5
(22) Date of filing: 14.06.2005
(51) Int. Cl.: B41C 1/10, G03F 7/00, G03F 7/027, G03F 7/028, G03F 7/031

(54) **Image recording material and lithographic printing plate precursor**
Bildaufzeichnungsmaterial und lithographischer Druckplattenvorläufer
Matériau d'enregistrement d'images et précurseur de plaque d'impression lithographique

(30) Priority: 18.06.2004 JP 2004181139
(43) Date of publication of application: 01.02.2006
(73) Proprietor: FUJIFILM Corporation, Minato-ku Tokyo (JP)
(72) Inventor: Inno, Toshifumi, Yoshida-cho Haibara-gun Shizuoka (JP); Kunita, Kazuto, Yoshida-cho Haibara-gun Shizuoka (JP)
(74) Representative: Hoffmann Eitle

(56) References cited:
- EP-A- 1 132 200
- EP-A- 1 393 899
- EP-A- 1 491 331
- GB-A- 1 453 681
- JP-A- 2002 202 594
- US-A- 4 168 982

## Description

### Background of the Invention

### 1. Field of the Invention

The present invention relates to an image recording material improved in the white light safety.

### 2. Description of the Related Art

In the field of lithographic printing, a computer-to-plate technique of producing a printing plate by exposing a lithographic printing plate precursor directly to a laser without intervention of a lith film based on digital data of a computer or the like has been developed, and a lithographic printing plate employing a high-sensitivity laser recording system using this technique has been developed.

However, conventional lithographic printing plates employing a high-sensitivity laser recording system have a problem that when the printing plate precursor is exposed by an inner drum-type plate setter with an Ar (488, 514.5 nm) or FD-YAG (532 nm) laser, which is most commonly used on the market, fogging is readily generated. More specifically, in the case where a negative printing plate precursor is used as the photosensitive material and an image like an entirely solid image is exposed on one surface of the plate, there arise troubles, for example, fogging having a bit of development failure is thinly generated when the opposite side is a non-image area, or a dot is thickened when a halftone image is present on the opposite side (at about 140 to 220° on the assumption that the opposite side is at 180° with respect to the light source). Thus, improvements are demanded.

Also, the high-sensitivity printing plate for conventional laser plate-making process using an Ar laser or an FD-YAG laser is, under red light, taken out from a corrugated board package, loaded into a cassette of a plate setter or sometimes manually inserted into a plate setter. In this way, all operations must be performed under dark red light and the workability is seriously bad. On the other hand, a normal diazo-type printing plate can be handled under yellow light or UV-cut white light and ensures good workability. The enhancement of safelight immunity of a high-sensitivity laser recording lithographic printing plate is greatly demanded on the market in view of workability.

To cope with this demand, JP-A-2000-35673 (the term "JP-A" as used herein means an "unexamined published Japanese patent application") describes a production method of a lithographic printing plate, where a lithographic printing plate comprising at least (A) an aluminum support and (B) a laser sensitive recording layer in this order is exposed by an inner drum-type plate setter using semiconductor laser light in the region from ultraviolet light to visible light (360 to 450 nm). According to this plate-making method, the plate can be handled under yellow light and even when the plate is exposed by an inner drum-type plate setter, fogging is not generated.

On the other hand, in the process of producing a conventional lithographic printing plate precursor, a step of dissolving and removing the unnecessary portion of the image recording layer after exposure, with a developer or the like is necessary. In recent years, as one problem to be solved, it is demanded to dispense with or simplify such an additional wet processing.

In order to satisfy this requirement, for example, a method called an on-press development has been proposed as one simple and easy plate-making method, where a lithographic printing plate precursor having an image recording layer dissolvable or dispersible with a printing ink and/or a fountain solution is used, and a lithographic printing plate is obtained by supplying a printing ink and/or a fountain solution to an exposed plate loaded on a printing press and thereby removing the unexposed area of the image recording layer.

For example, JP-A-47-8657 describes a photosensitive composition comprising a polyvinylpyrrolidone, a polymer polycarboxylic acid and an olefinically unsaturated monomer and, if desired, containing a photoinitiator and a polymerization inhibitor, with which a printing plate loadable on a printing press immediately after exposure without applying any processing and usable for printing can be obtained.

However, when an image recording system utilizing light in the region from ultraviolet light to visible light is applied to such a non-processing printing plate not requiring a development processing with a developer, the image recording layer is not fixed and still has photosensitivity to room light even after exposure and therefore, the plate must be kept in an absolutely light-shielded state after the lithographic printing plate precursor is taken out from the package until the on-press development is completed or must be dealt with in a safelight environment. Otherwise, for example, when the plate after exposure is dealt with under white light, the unnecessary portion of the image recording layer is fogged to allow for film remaining and this causes print staining. Accordingly, the operation of a printing press which does not originally require safelight must be also performed in a safelight environment and this is detrimental to the printing operation such as color adjustment. A non-processing printing plate system operable under white light is being demanded.

US 4168982 discloses thermally stable photopolymerizable compositions comprising (i) at least one nongaseous ethylenically unsaturated compound, (ii) a nitroso dimer which is a noninhibitor of free-radical polymerization but thermally dissociates to nitroso monomer which is an inhibitor of free-radical polymerization, and (iii) an organic, radiation-sensitive free-radical generating system.

JP2002202594 describes a printing plate material comprising a polymerizable compound, a polymerization initiator and a photopolymerization inhibitor.

GB1453681 also concerns a photopolymerizable composition comprising a polymerizable compound, a light sensitive free radical generating system and a nitroso dimer used as a photopolymerization inhibitor.

### Summary of the Invention

An object of the present invention is to satisfy the above-described requirement. That is, an object of the present invention is to provide an image recording material ensuring excellent white light safety without decreasing the sensitivity at the image exposure.

The present invention is as follows.
1. An image recording material comprising (A) a polymerization initiator, (B) a polymerizable compound, and (C) a compound capable of generating, when heated, a chemical species capable of inhibiting a polymerization reaction, wherein the compound (C) has a phenolic hydroxyl group protected with a group decomposable under heat.
2. The image recording material as described in 1 above, which has photosensitivity in the range from 250 to 420 nm.
3. The image recording material as described in 1 above, which further comprises an infrared absorbent.
4. A method for inhibiting a polymerization reaction of an image recording material after imagewise exposure, comprising imagewise exposing and then heat-treating the image recording material described in any one of 1 to 3 above.
5. The method for inhibiting a polymerization reaction of an image recording material after imagewise exposure as described in 4 above, wherein the light source for imagewise exposure is laser light.
6. A lithographic printing plate precursor comprising a support having thereon an image recording layer comprising an image recording material as defined in 1 above.
7. The lithographic printing plate precursor as described in 6 above, wherein the image recording layer has photosensitivity in the range from 250 to 420 nm.
8. The lithographic printing plate precursor as described in 6 above, wherein the image recording layer further comprises an infrared absorbent.
9. An on-press development method wherein the image recording layer is removed from the lithographic printing plate precursor as defined in 6 above with at least one of a printing ink and a fountain solution.

When an image recording material utilizing a polymerization reaction is exposed to white light after image exposure, the unexposed area causes a polymerization reaction to generate fogging. If a polymerization inhibitor is added to the image recording material so as to prevent this polymerization, the white light fogging may be prevented but the sensitivity at the image formation (polymerization reaction) is also decreased. The present inventors have found that by incorporating a compound as defined in claim 1 which is capable of generating, when heated, a chemical species capable of inhibiting a polymerization reaction into an image recording material such as lithographic printing plate precursor, and heating the image recording material after image exposure to produce a polymerization inhibitor, white light fogging in the non-image area can be prevented and at the same time, sensitivity in the image area can be ensured. The present invention has been accomplished based on this finding.

### Brief Description of the Drawings

Fig. 1 is a side view showing the construction of an image exposure apparatus;
Fig. 2 is a side view showing the construction of an exposure apparatus employing a system of exposure and then heating (surface heating);
Fig. 3 is a perspective view showing an exposure head (local heating simultaneously with exposure) in the image exposure apparatus shown in Fig. 1 and a feeding mechanism thereof; and
Fig. 4 is a perspective view showing an exposure head (local heating after exposure) in the image exposure apparatus shown in Fig. 1 and a feeding mechanism thereof.

10 denotes an image exposure apparatus; 12 denotes a lithographic printing plate precursor; 14 denotes a casing; 16 denotes a plate supply table; 18 denotes a discharge tray; 20 denotes an outer drum; 22 denotes a chuck mechanism (holding member); 24 denotes a guide roller; 26 denotes an exposure head (exposure means); 28 denotes a feeding mechanism (exposure means); 30 denotes a light source box; 32 denotes a light source device; 34 denotes a supply and feeding mechanism; 35 denotes a transportation roller; 36 denotes a guide member; 38 denotes a heating device; 40 denotes a heat-resistant film; 42 denotes a film guide; 44 denotes a pressure roller; 45 denotes a bend part; 46 denotes a blow port; 48 denotes a heating part; 50 denotes an air feeding part; 52 denotes an elastic layer; 54 denotes an excitation coil; 56 denotes a temperature sensor; 58 denotes a lens unit; 60 denotes a fiber holder (exposure head); 62 denotes a guide rail; 64 denotes a motor unit; 66 denotes a screw shaft; 68 denotes a carrier (carrier member); 69 denotes a female screw member; 70 denotes an optical fiber; 72 denotes a laser; 74 denotes a heat sink; 76 denotes a connector array; 78 denotes a cable bear; 80 denotes a bear guide; 82 denotes a linking strip; 84 denotes an exporting mechanism; 86 denotes a transportation roller; 88 denotes a guide member; 140 denotes a heating fan unit (heating means); 142 denotes a flexible duct (heating means); 144 denotes a hot air nozzle (heating means); 146 denotes a heating member; 148 denotes a coil unit; 150 denotes a core grid; L denotes Laser light; R1, R2 denote drum rotation directions; S denotes Exposure head feeding direction; A_{IR} denotes an exposure region; and A_{HT} denotes a heating region.

### Detailed Description of the Invention

The image recording material of the present invention is characterized by comprising (A) a polymerization initiator, (B) a polymerizable compound, and (C) a compound capable of generating, when heated, a chemical species capable of inhibiting a polymerization reaction as defined in claim 1.

The image recording material which can be suitably used is a lithographic printing plate precursor comprising a support having thereon an image recording layer comprising (A) a polymerization initiator, (B) a polymerizable compound, and (C) a compound capable of generating, when heated, a chemical species capable of inhibiting a polymerization reaction as defined in claim 1. With such a constitution, a polymerization inhibitor can be generated in the image recording material (image recording layer) by heating the image recording material after image exposure, whereby the white light safety in subsequent handling of the image recording material (lithographic printing plate precursor) can be enhanced without decreasing the sensitivity at the image exposure.

The image recording layer according to the present disclosure is preferably an image recording layer removable with a printing ink and/or a fountain solution. With such an image recording layer, an on-press developable lithographic printing plate precursor having excellent white light safety can be obtained.

### <(C) Compound capable of generating, when heated, a chemical species capable of inhibiting polymerization reaction>

The compound (C) capable of generating, when heated, a chemical species capable of inhibiting a polymerization reaction for use in the present invention is a compound capable of decomposing under the action of heat to generate a radical polymerization inhibitor (hereinafter, this compound is sometimes referred to as a "polymerization inhibitor precursor").

The radical polymerization inhibitor as used herein means a compound capable of stopping or inhibiting a radical polymerization reaction which is a phenol.

Examples of phenols include phenol, p-methoxyphenol, 2,6-di-tert-butyl-4-methoxyphenol, 2,6-di-tert-butyl-4-cresol, hydroquinone, catechol, tert-butyl catechol, pyrogallol, resorcinol, 4,4'-thiobis(3-methyl-6-tert-butylphenol), 2,2'-methylenebis(4-methyl-6-tert-butylphenol), phenylhydroquinone, hydroquinone, tert-butylhydroquinone, and 2,5-di-tert-butylhydroquinone.

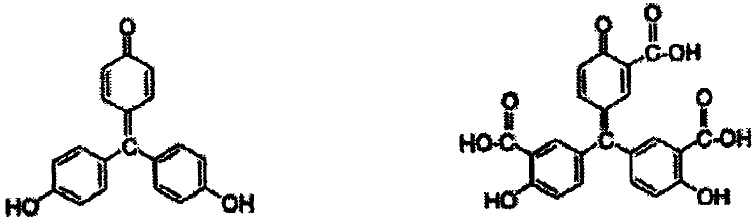

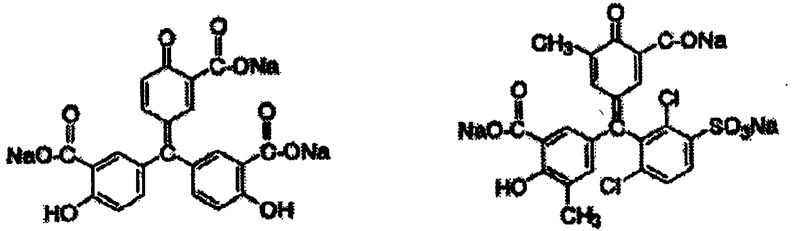

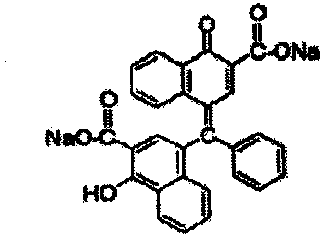

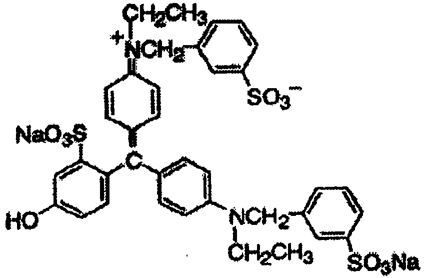

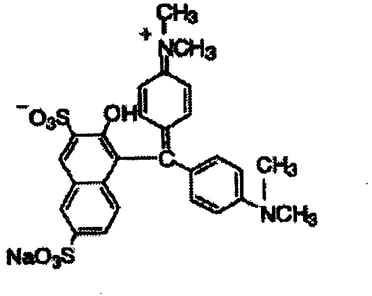

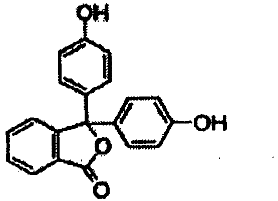

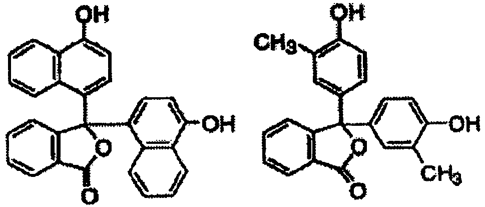

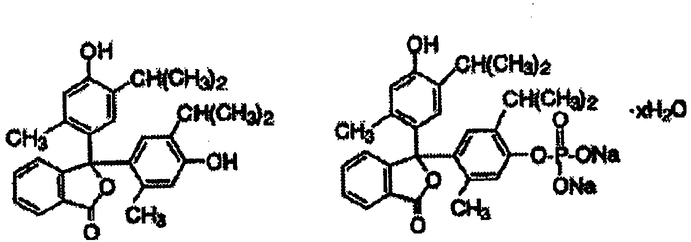

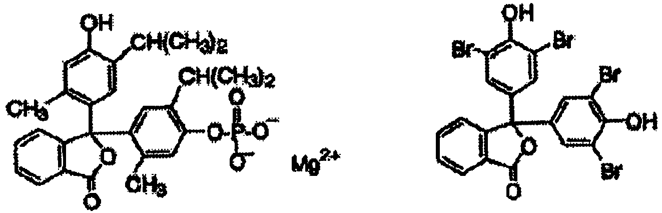

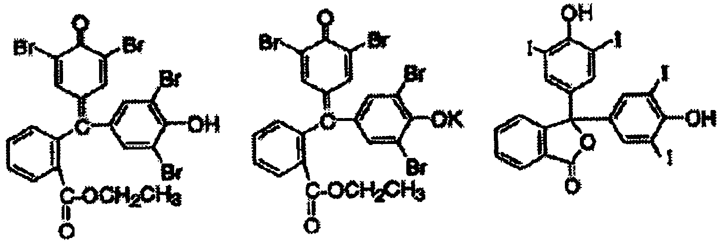

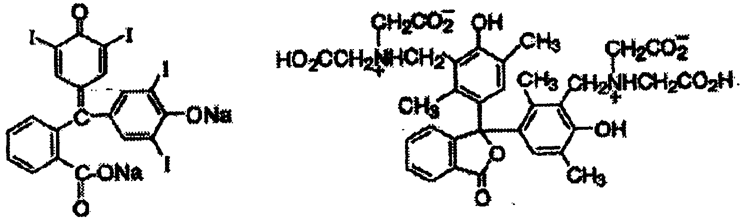

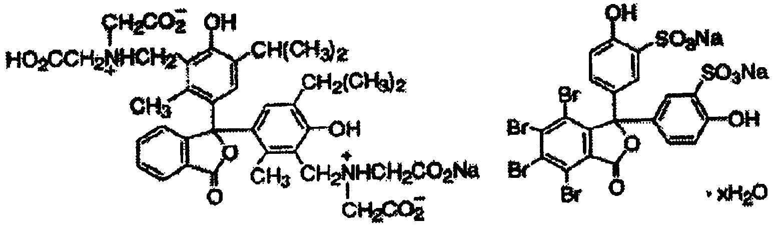

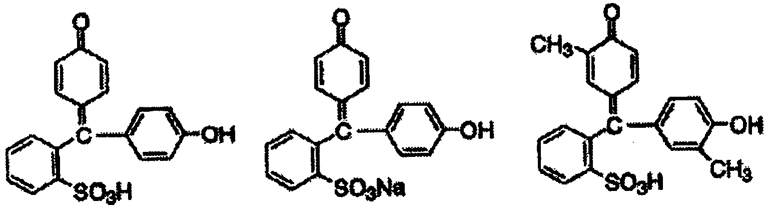

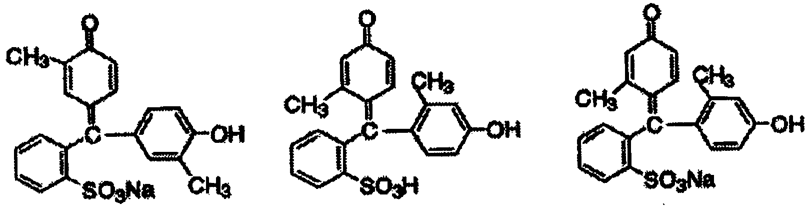

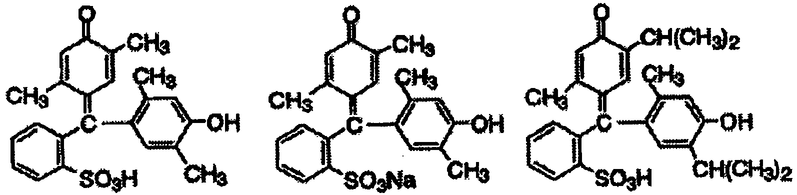

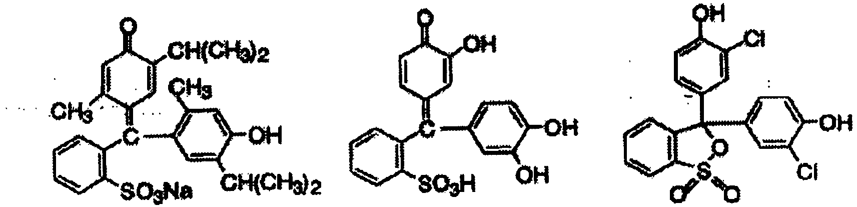

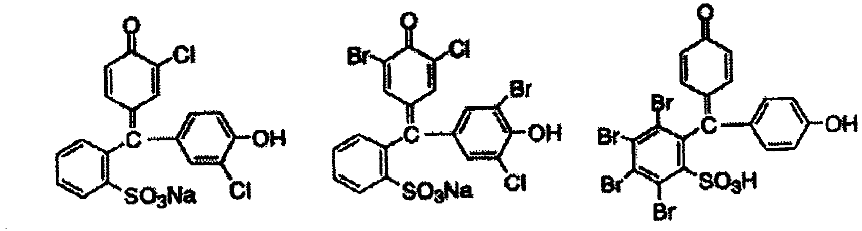

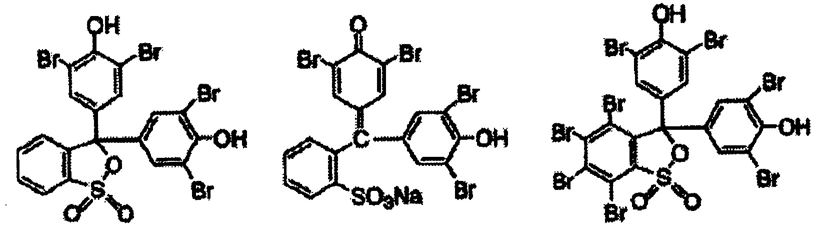

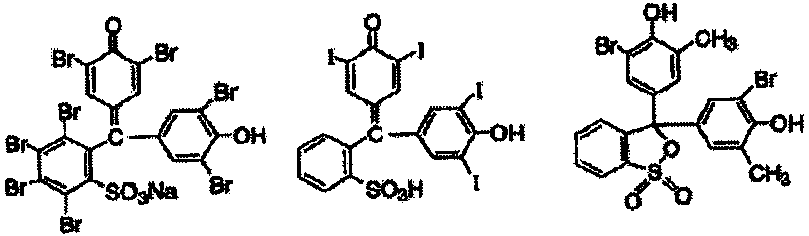

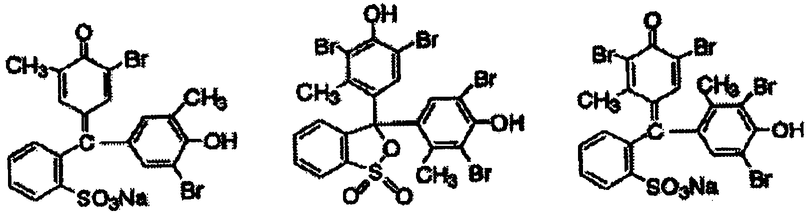

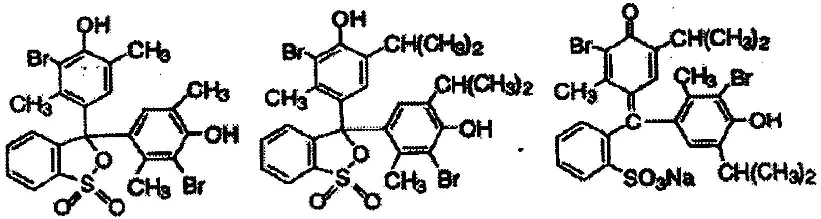

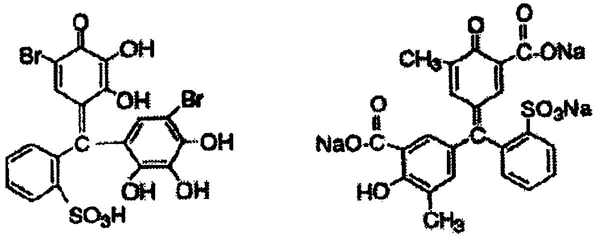

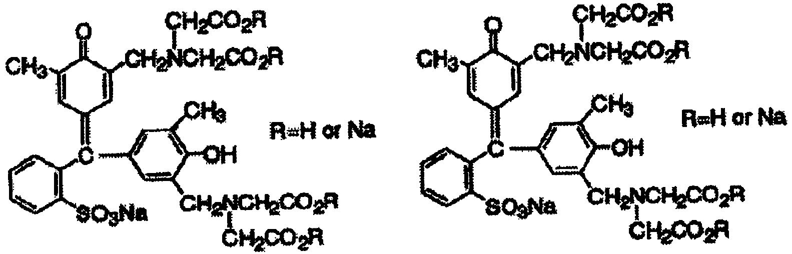

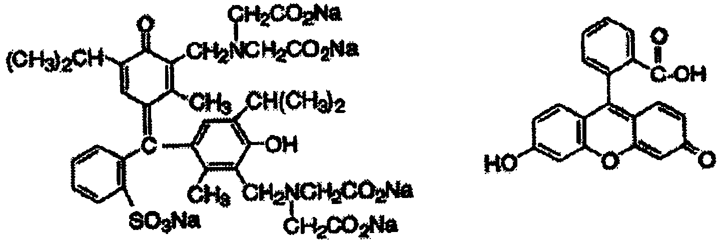

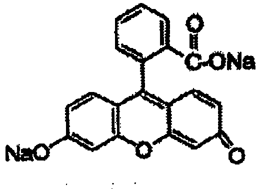

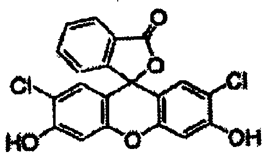

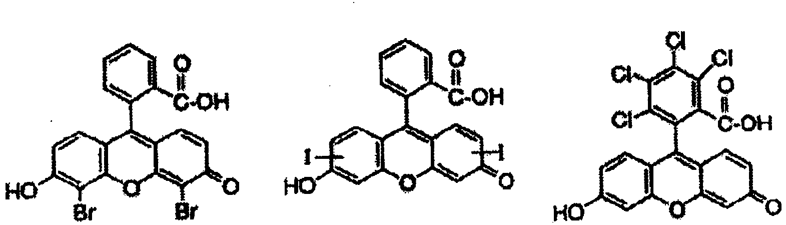

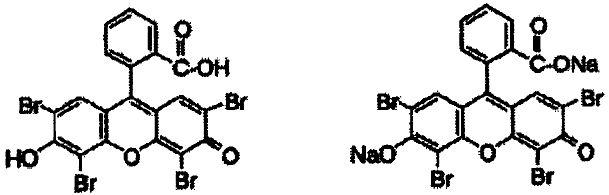

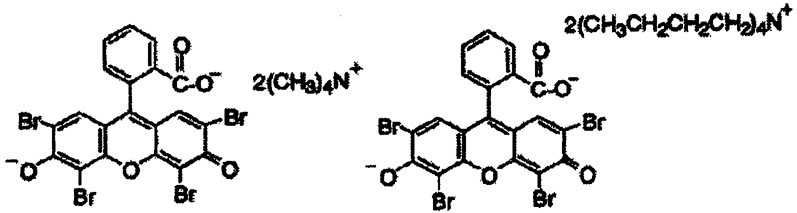

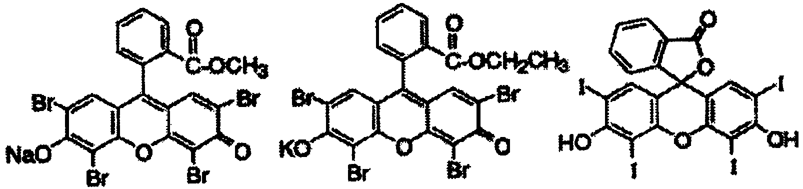

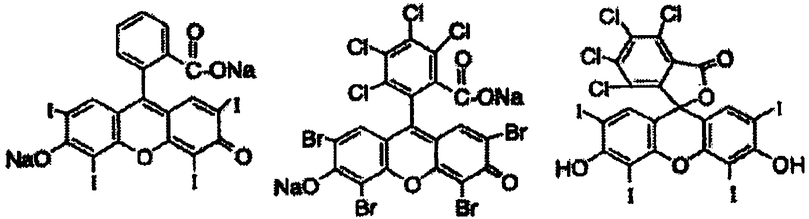

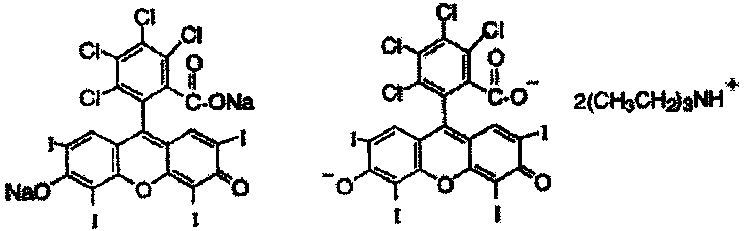

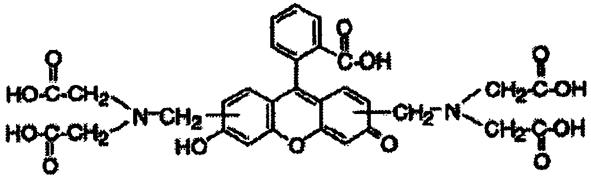

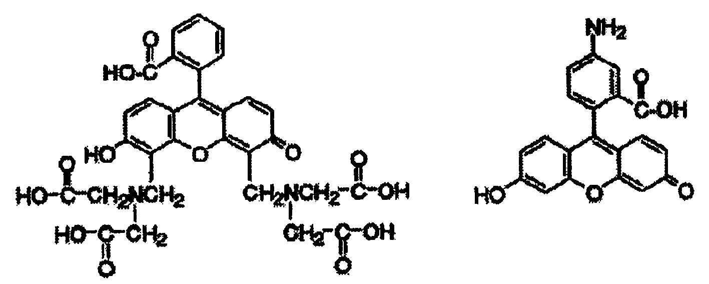

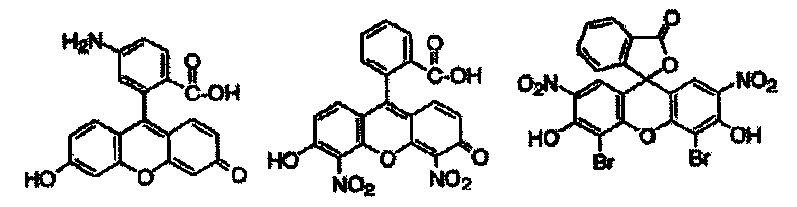

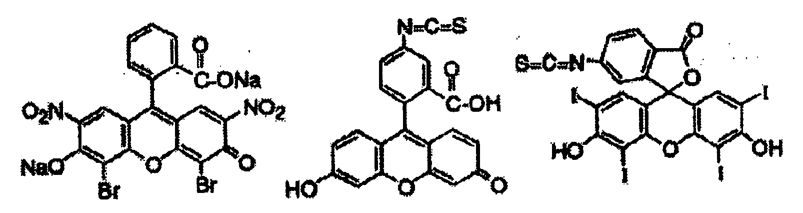

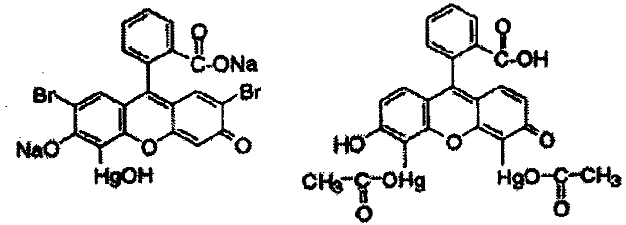

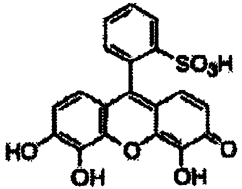

The polymerization inhibitor precursor of the present invention is a compound capable of decomposing under heat to produce the above-described thermopolymerization inhibitor, and is a compound having a phenolic hydroxyl group protected with a thermally decomposable group.

Specific examples of the polymerization inhibitor precursor for use in the present invention are set forth below, but the present invention is not limited thereto. I-4, I-5, I-6 and I-13 are included for reference only and do not form part of the invention.

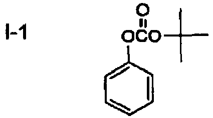

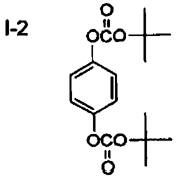

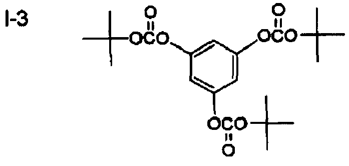

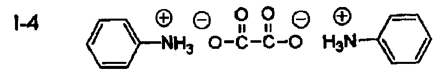

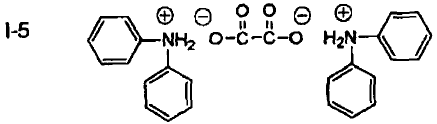

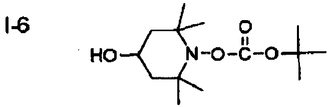

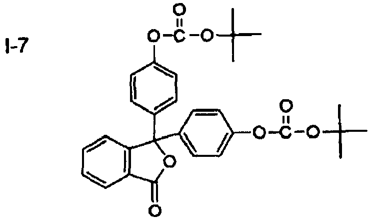

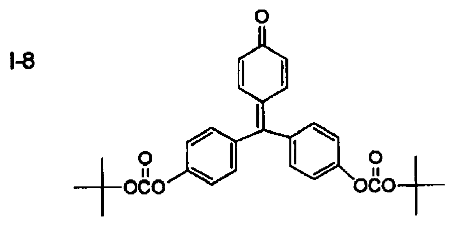

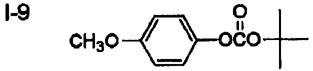

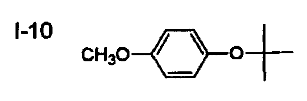

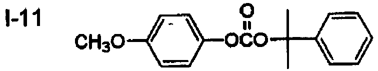

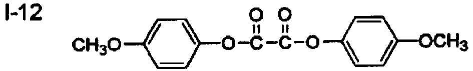

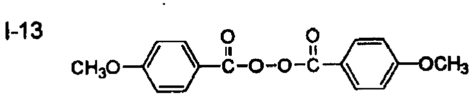

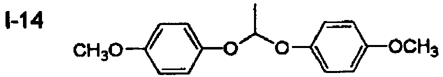

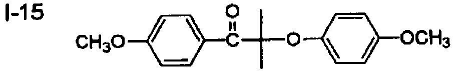

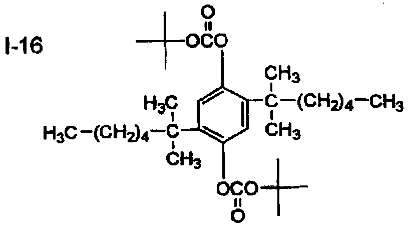

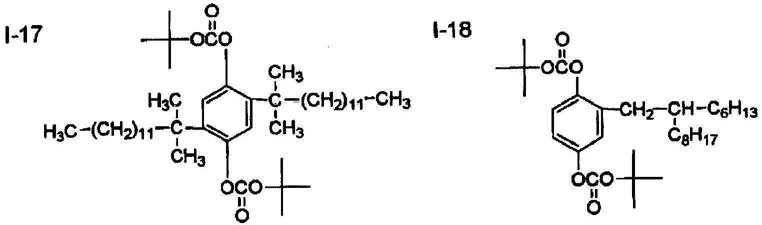

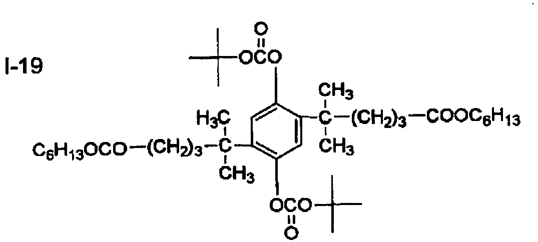

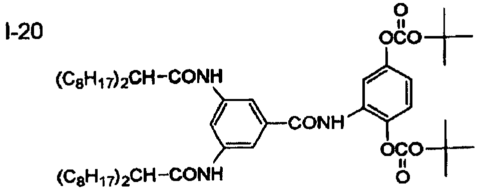

The amount of the polymerization inhibitor precursor added is preferably from 0.01 to 15 mass%, more preferably from 0.1 to 10 mass%, and most preferably from 0.5 to 5 mass%, based on the entire solid content of the image recording layer.

When the polymerization inhibitor precursor is used in combination with a strong acid or an acid generator, the thermal decomposition efficiency is elevated and this is preferred. Preferred examples of the strong acid include acids with a pKa of 3 or less. Among these, more preferred is a sulfonic acid, and most preferred is a sulfonic acid containing a halogen atom. Preferred examples of the acid generator include compounds capable of generating the above-described acid with a pKa of 3 or less. Among these, more preferred are a diazonium salt, a sulfonium salt, an iodonium salt and a sulfonic acid ester.

### <Heating Method>

The method for heating the lithographic printing precursor after image exposure is not particularly limited and a known heating method can be used. Examples thereof include a direct heating method of contacting the plate with a heat source such as heat roller, a heating method of blowing hot air, a heating method of irradiating infrared rays generated from an infrared emitter such as halogen heater or ceramic heater, an electromagnetic heating method of irradiating an electron magnetic wave at a predetermined wavelength generated from a magnetron and resonating substances such as water content contained in the image recording layer, and an induction heating method of applying a high-frequency magnetic field to a metal-made lithographic printing plate support from an electromagnetic coil.

The heating temperature is preferably from 75 to 250°C, more preferably from 90 to 180°C, and the heating time is preferably from 1 to 600 seconds, more preferably from 10 to 180 seconds.

The heating method which can be employed in the present invention is described in detail below by referring to the drawings.

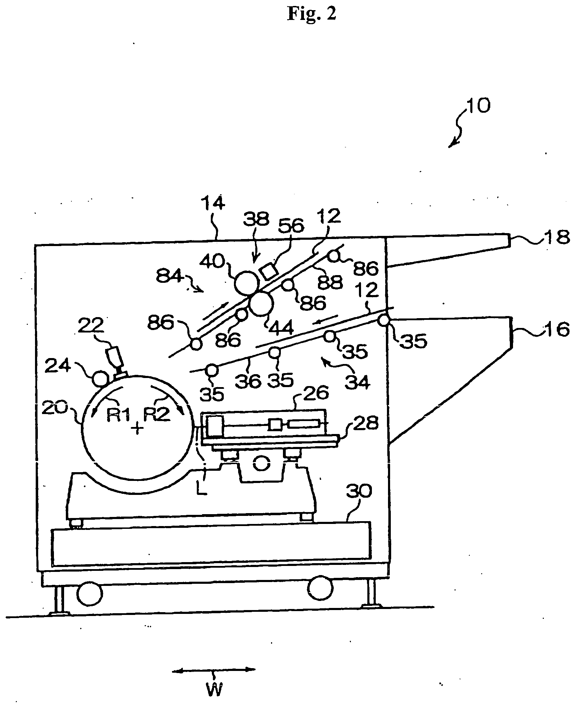

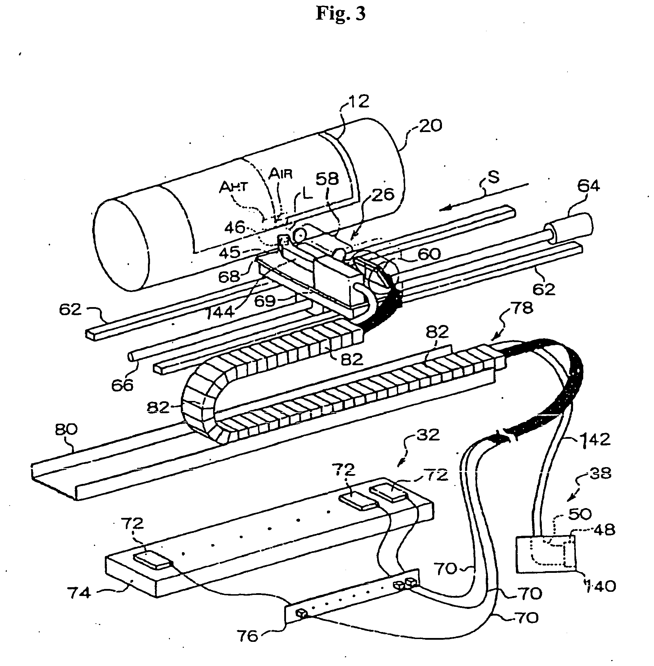

As shown in Figs. 2, 3 and 4, the image exposure apparatus 10 used in the case of applying heat after exposure preferably comprises a heating device 38 disposed, for example, in a casing 14. The heating device 38 locally heats (spot-heating) the lithographic printing plate precursor 12 with hot air and, as shown in Fig. 3, comprises a heating fan unit 140 and a tubular hot air nozzle 144 connected to the heating fan unit 140 through a flexible duct 142. The heating fan unit 140 is fixed in the casing 14, and the hot air nozzle 144 is mounted together with an exposure head 26 on a carrier 68. The portion on the distal end side of the flexible duct 142 passes together with a bundle of optical fibers through a cable bear.

The hot air nozzle 144 on the carrier 68 is disposed to come adjacent to the exposure head 26 along the sub-scanning direction. The hot air nozzle 144 is supported by extending its basal end side in parallel with the traveling direction of laser light L and at the distal end part, a bend part 45 bent from the basal end side toward the distal end surface to face the exposure region A_{IR} on a lithographic printing plate precursor 12 is formed. On the distal end surface of this bend part 45, a rectangular blow port is opened.

In the heating fan unit 140, a heating part 48 comprising a heater such as halogen heater or ceramic heater for heating air taken in from the outside of the casing 14, and an air supply part 50 for supplying the heated air in a pressurized state into the flexible duct 142 are provided. The high-temperature air supplied into the flexible duct 142 is supplied to the hot air nozzle 144 and blown as hot air from the blow port 46 of the hot air nozzle 144 onto a lithographic printing plate precursor 12 loaded on an outer drum 20. At this time, the bend part 45 of the hot air nozzle 144 faces the exposure region A_{IR} on the lithographic printing plate precursor 12 and therefore, the hot air belched out from the blow port 46 is blown on the region (hereinafter, sometimes referred to as a "heating region A_{HT}") overlapping with the exposure region A_{IR} of the lithographic printing plate precursor 12, as a result, the recording layer in the heating region A_{HT} is heated to a predetermined heating temperature.

The heating region A_{HT} has a center nearly agreeing with the center of the exposure region A_{IR} and the size thereof is sufficiently larger than the exposure region A_{IR} in both the sub-scanning direction and the main scanning direction. By such a constitution, the heating region A_{HT} above the lithographic printing plate precursor 12 can include the exposure region A_{IR} and when the hot air belched from the blow port 46 is blown on the heating region A_{HT} including the exposure region A_{IR} at the same time with irradiation of laser light L on an arbitrary exposure region A_{IR} of the lithographic printing plate precursor 12, exposure starts in the exposure region A_{IR} by the action of laser light L and the heating region A_{TH} is heated to a predetermined heating temperature during the exposure from the initiation of exposure to the completion of exposure.

The exposure time from the start of exposure in an arbitrary exposure region A_{IR} by the action of laser light L until the completion of exposure is nearly agreeing with the modulation cycle of laser light L according to the sub-scanning speed and is usually as short as about 0.05 seconds. In order to heat the lithographic printing plate precursor to a desired heating temperature, for example, with hot air in such a short time, the hot air temperature must be made extremely high but this is not practical. Accordingly, the length of the heating region A_{HT} along the sub-scanning direction is preferably from 50 to 100 times that of the exposure region A_{IR}, so that the hot air heating of an arbitrary exposure region A_{IR} included in the heating region A_{HT} can continue over from 106 to 107 times the modulation cycle. With this constitution, the heating time for an arbitrary exposure region A_{IR} can be satisfactorily prolonged and therefore, the exposure region A_{IR} can be stably heated to a predetermined heating temperature even when the hot air temperature is not made extremely high.

In the image exposure apparatus 10, a heating control part for controlling the heating device 38 is provided. This heating control part controls the temperature and quantity of the hot air supplied from the heating fan unit 140 to the hot air nozzle 144. Also, by mounting a temperature sensor such as infrared radiation thermometer on the carrier 68 and measuring the temperature (surface temperature) of the heating region A_{HT} with use of the temperature sensor, the measurement signal corresponding to the surface temperature in the center part of the heating region A_{HT} can be output to the heating control part. With this constitution, the heating control part can feedback control the temperature of the heating region A_{HT} based on the measurement signal, and the temperature in the center part of the heating region A_{HT} can be stably maintained to the heating temperature with good precision.

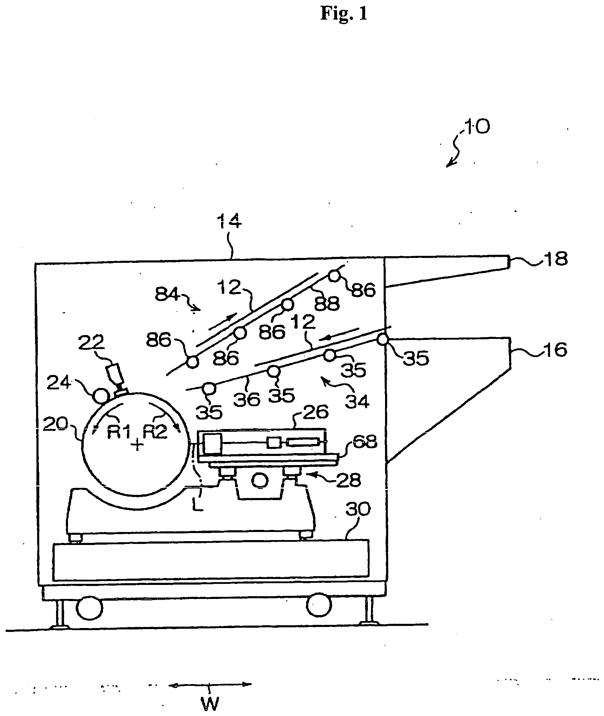

As shown in Fig. 1, in the casing 14 of the image exposure 10, a transportation mechanism 84 for transporting the lithographic printing plate precursor 12 released from the outer drum 20 to a discharge tray 18 is provided. This transportation mechanism 84 comprises a plurality of transportation rollers 86 disposed along the transportation route for the lithographic printing plate precursor 12, and a plate-like guide member 88.

In the image exposure apparatus 10, after the completion of exposure (image formation) for the lithographic printing plate precursor 12 loaded on the outer drum 20, the outer drum 20 is rotated in the reverse direction (in the arrow R2 direction in Fig. 1) and at the same time, the rear end part and the leading end part of the lithographic printing plate precursor 12 are sequentially released from the outer drum by a chuck mechanism 22. In conjunction with this, the transportation mechanism 84 starts transporting the lithographic printing plate precursor 12 delivered from the outer drum 20 and reached the entrance part of the discharge route to the discharge tray by rotating the transportation rollers 86 and discharges the lithographic printing plate precursor 12 onto the discharge tray 18.

The heating device 38 of the image exposure apparatus 10 according to the present invention employs a system of blowing hot air directly to the lithographic printing plate precursor 12 surface and thereby spot-heating the heating region A_{HT} of the lithographic printing plate precursor 12, but the heating device is not limited to those using hot air and, for example, an infrared emitter such as halogen heater or ceramic heater may be mounted on the carrier to irradiate the lithographic printing plate precursor 12 with infrared rays generated from the emitter and thereby spot-heat the heating region A_{HT}, a magnetron may be mounted on the carrier 68 to irradiate the recording layer of the lithographic printing plate precursor 12 with an electromagnetic wave at a predetermined wavelength generated from the magnetron and resonate substances such as water in the recording layer, thereby effecting spot-heating (electromagnetic heating), or an electromagnetic coil may be mounted on the carrier 68 to apply a high-frequency magnetic field from the electromagnetic coil to the metal-made support of the lithographic printing plate precursor 12 and thereby spot-heat the support (induction heating).

### <(A) Polymerization Initiator>

The polymerization initiator for use in the present invention is a compound capable of generating a radical by the effect of either one or both of light and heat energies and thereby initiating or accelerating the polymerization of a compound having a polymerizable unsaturated group. In particular, when the polymerization initiator is used alone or used in combination with a sensitizing dye which is described later, a compound capable of generating a radical by absorbing light at 250 to 420 nm, and a compound capable of generating a radical in combination with an infrared absorbent are preferred. Such a photo-radical generator may be appropriately selected and used from known polymerization initiators, compounds having a bond small in the bond-dissociation energy, and the like.

Examples of the compound capable of generating a radical include organohalogen compounds, carbonyl compounds, organic peroxides, azo-based compounds, azide compounds, metallocene compounds, hexaarylbiimidazole compounds, organoboron compounds, disulfone compounds, oxime ester compounds and onium salt compounds.

Specific examples of the organohalogen compound include the compounds described in Wakabayashi et al., Bull. Chem. Soc. Japan, 42, 2924 (1969), U.S. Patent 3,905,815, JP-B-46-4605 (the term "JP-B" as used herein means an "examined Japanese patent publication"), JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339, and M.P. Hutt, Journal of Heterocyclic Chemistry, 1, No. 3 (1970). Among these, oxazole compounds substituted with a trihalomethyl group and s-triazine compounds are preferred.

s-Triazine derivatives where at least one mono-, di- or tri-halogenated methyl group is bonded to the s-triazine ring, and oxadiazole derivatives where that methyl group is bonded to the oxadiazole ring, are more preferred. Specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and compounds shown below.

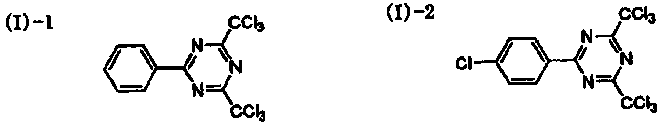

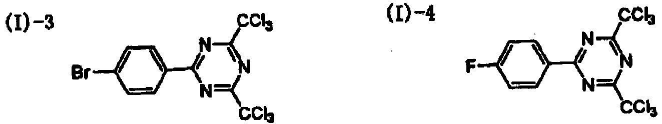

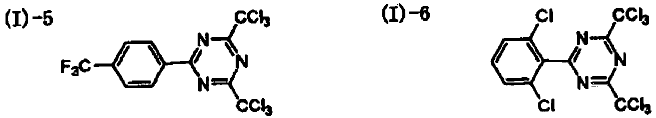

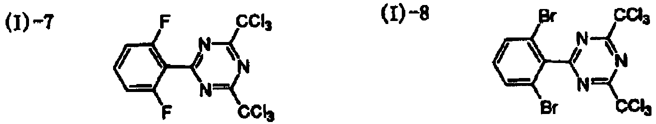

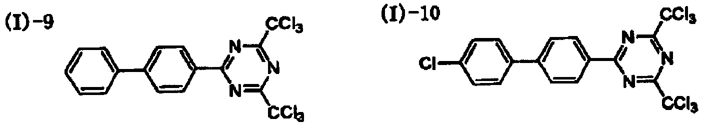

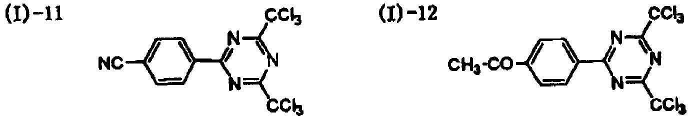

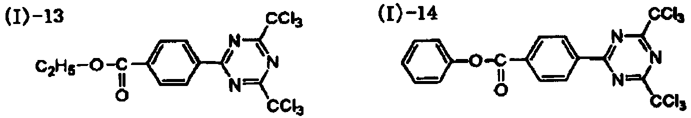

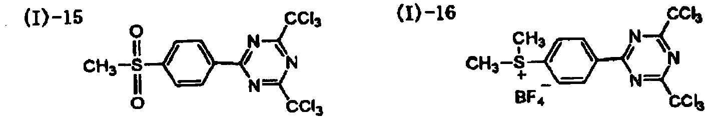

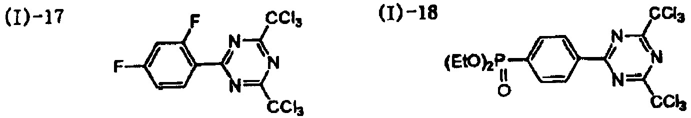

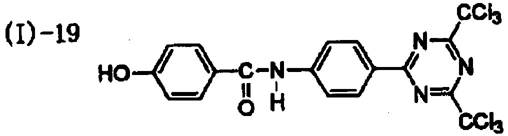

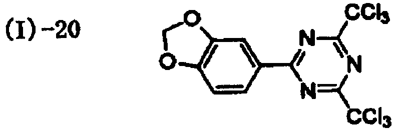

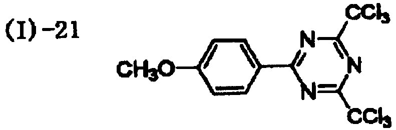

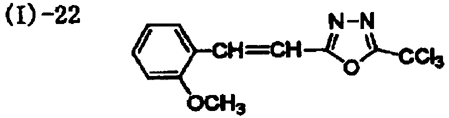

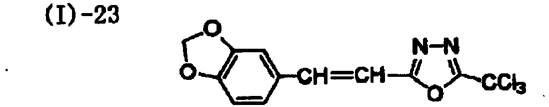

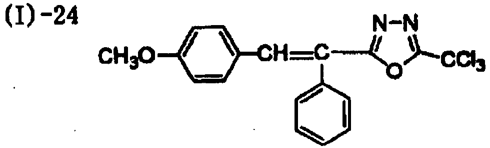

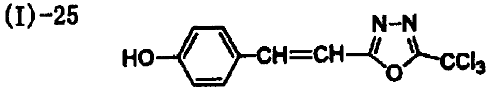

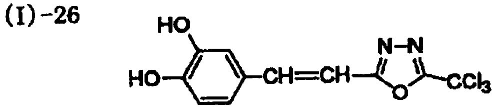

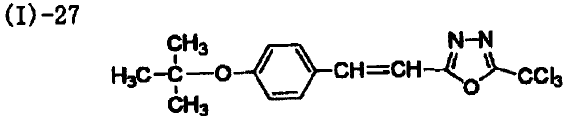

Examples of the carbonyl compound include benzophenone derivatives such as benzophenone, Michler's ketone, 2-methylbenzophenone, 3-methylbenzophenone, 4-methylbenzophenone, 2-chlorobenzophenone, 4-bromobenzophenone and 2-carboxybenzophenone; acetophenone derivatives such as 2,2-dimethoxy-2-phenylacetophenone, 2,2-diethoxyacetophenone, 1 -hydroxycyclohexylphenylketone, α-hydroxy-2-methylphenylpropanone, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; thioxanthone derivatives such as thioxanthone, 2-ethylthioxanthone, 2-isopropylthioxanthone, 2-chlorothioxanthone, 2,4-dimethylthioxanthone, 2,4-diethylthioxanthone and 2,4-diisopropylthioxanthone; and benzoic acid ester derivatives such as ethyl p-dimethylaminobenzoate and ethyl p-diethylaminobenzoate.

Examples of the azo-based compound which can be used include azo compounds described in JP-A-8-108621.

Examples of the organic peroxide include trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, succinic peroxide, benzoyl peroxide, 2,4-dichlorobenzoyl peroxide, diisopropylperoxydicarbonate, di-2-ethylhexylperoxydicarbonate, di-2-ethoxyethylperoxydicarbonate, dimethoxyisopropylperoxycarbonate, di(3-methyl-3-methoxybutyl)peroxydicarbonate, tert-butylperoxyacetate, tert-butylperoxypivalate, tert-butylperoxyneodecanoate, tert-butylperoxyoctanoate, tert-butylperoxylaurate, tert-carbonate, 3,3',4,4'-tetra(tert-butyl-peroxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogendiphthalate) and carbonyl di(tert-hexylperoxydihydrogendiphthalate).

Examples of the metallocene compound include various titanocene compounds described in JP-A-59-152396, JP-A-61-151197, JP-A-63-41484, JP-A-2-249, JP-A-2-4705 and JP-A-5-83588, such as dicyclopentadienyl-Ti-bis-phenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadienyl-Ti-bis-2,3,5,6-tetrafluorophen-1-yl and dimethylcyclopentadienyl-Ti-bis-2,3,4,5,6-pentafluorophen-1-yl, and iron-allene complexes described in JP-A-1-304453 and JP-A-1-152109.

Examples of the hexaarylbiimidazole compound include various compounds described in JP-B-6-29285 and U.S. Patents 3,479,185, 4,311,783 and 4,622,286, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluorophenyl)-4,4',5,5'-tetraphenylbiimidazole.

Examples of the organoboron compound include organic borates described in JP-A-62-143044, JP-A-62-150242, JP-A-9-188685, JP-A-9-188686, JP-A-9-188710, JP-A-2000-131837, JP-A-2002-107916, Japanese Patent No. 2764769, JP-A-2002-116539, and Martin Kunz, Rad Tech. '98. Proceeding April 19-22, 1998, Chicago; organic boron sulfonium complexes and organic boron oxosulfonium complexes described in JP-A-6-157623, JP-A-6-175564 and JP-A-6-175561; organic boron iodonium complexes described in JP-A-6-175554 and JP-A-6-175553; organic boron phosphonium complexes described in JP-A-9-188710; and organic boron transition metal coordination complexes described in JP-A-6-348011, JP-A-7-128785, JP-A-7-140589, JP-A-7-306527 and JP-A-7-292014.

Examples of the disulfone compound include compounds described in JP-A-61-166544 and JP-A-2003-328465.

Examples of the oxime ester compound include compounds described in J.C.S. Perkin II, 1653-1660 (1979), J.C.S. Perkin II, 156-162 (1979), Journal of Photopolymer Science and Technology, 202-232 (1995), JP-A-2000-66385 and JP-A-2000-80068. Specific examples thereof include the compounds represented by the following structural formulae.

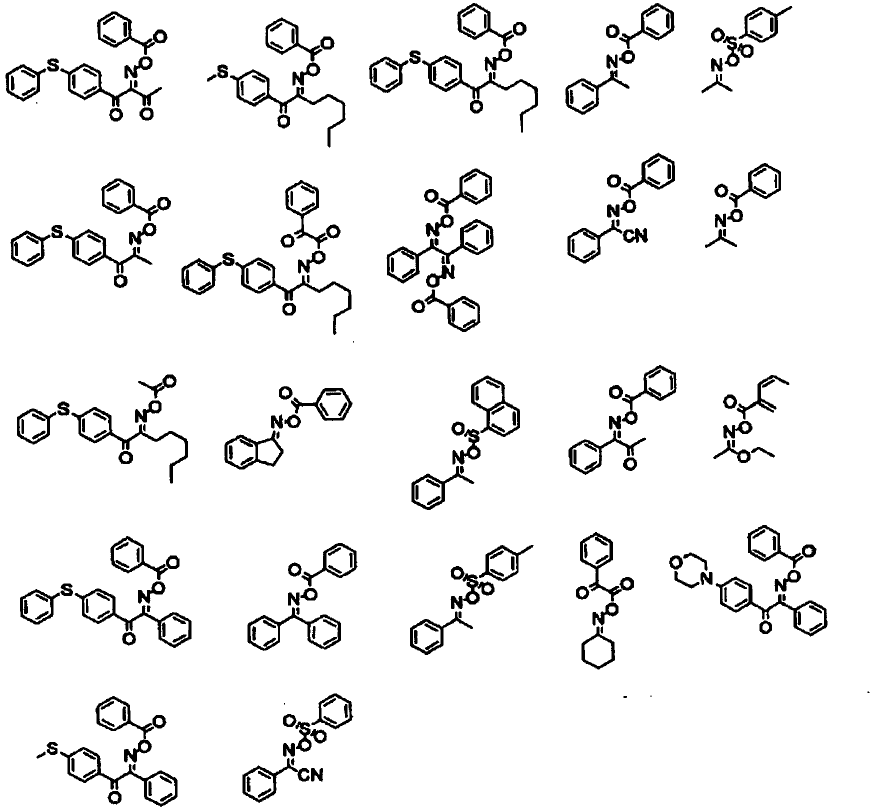

Examples of the onium salt compound include onium salts such as diazonium salts described in S.I. Schlesinger, Photogr. Sci. Eng., 18, 387 (1974) and T.S. Bal et al., Polymer, 21, 423 (1980); ammonium salts described in U.S. Patent 4,069,055 and JP-A-4-365049; phosphonium salts described in U.S. Patents 4,069,055 and 4,069,056; iodonium salts described in European Patent 104,143, U.S. Patents 339,049 and 410,201, JP-A-2-150848 and JP-A-2-296514; sulfonium salts described in European Patents 370,693, 390,214, 233,567, 297,443 and 297,442, U.S. Patents 4,933,377, 161,811, 410,201, 339,049, 4,760,013, 4,734,444 and 2,833,827, and German Patents 2,904,626, 3,604,580 and 3,604,581; selenonium salts described in J.V. Crivello et al., Macromolecules, 10 (6), 1307 (1977) and J.V. Crivello et al., J. Polymer Sci., Polymer Chem. Ed., 17, 1047 (1979); and arsonium salts described in C.S. Wen et al., Teh. Proc. Conf. Rad. Curing ASIA, p. 478 (Tokyo, Oct. 1988).

In the present invention, such an onium salt functions as an ionic radical polymerization initiator but not as an acid generator.

The onium salt suitably used in the present invention is an onium salt represented by any one of the following formulae (RI-I) to (RI-III):

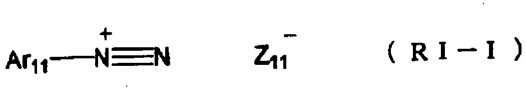

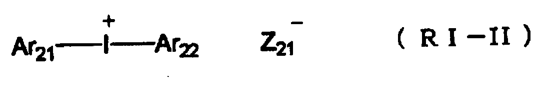

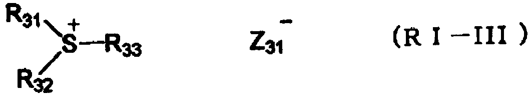

In formula (RI-I), Ar₁₁ represents an aryl group having 20 or less carbon atoms, which may have from 1 to 6 substituent(s), and preferred examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamide or arylamide group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. Z₁₁⁻ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability are perchlorate ion, hexafluorophosphate ion, tetrafluoroborate ion, sulfonate ion and sulfinate ion.

In formula (RI-II), Ar₂₁ and Ar₂₂ each independently represents an aryl group having 20 or less carbon atoms, which may have from 1 to 6 substituent(s), and preferred examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. Z₂₁⁻ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability and reactivity are perchlorate ion, hexafluorophosphate ion, tetrafluoroborate ion, sulfonate ion, sulfinate ion and carboxylate ion.

In formula (RI-III), R₃₁, R₃₂ and R₃₃ each independently represents an aryl, alkyl, alkenyl or alkynyl group having 20 or less carbon atoms, which may have from 1 to 6 substituent(s), and in view of reactivity and stability, preferably an aryl group. Examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. Z₃₁⁻ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability and reactivity are perchlorate ion, hexafluorophosphate ion, tetrafluoroborate ion, sulfonate ion, sulfinate ion and carboxylate ion, more preferred is carboxylate ion described in JP-A-2001-343742, still more preferred is carboxylate ion described in JP-A-2002-148790.

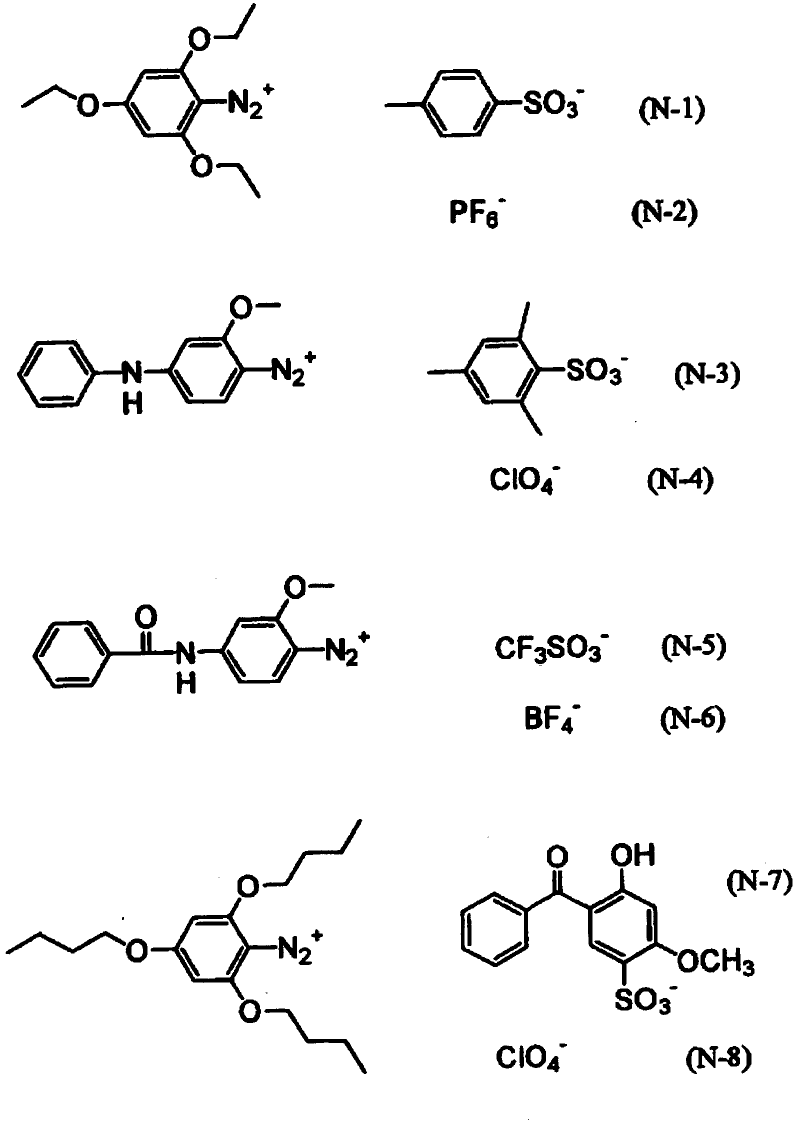

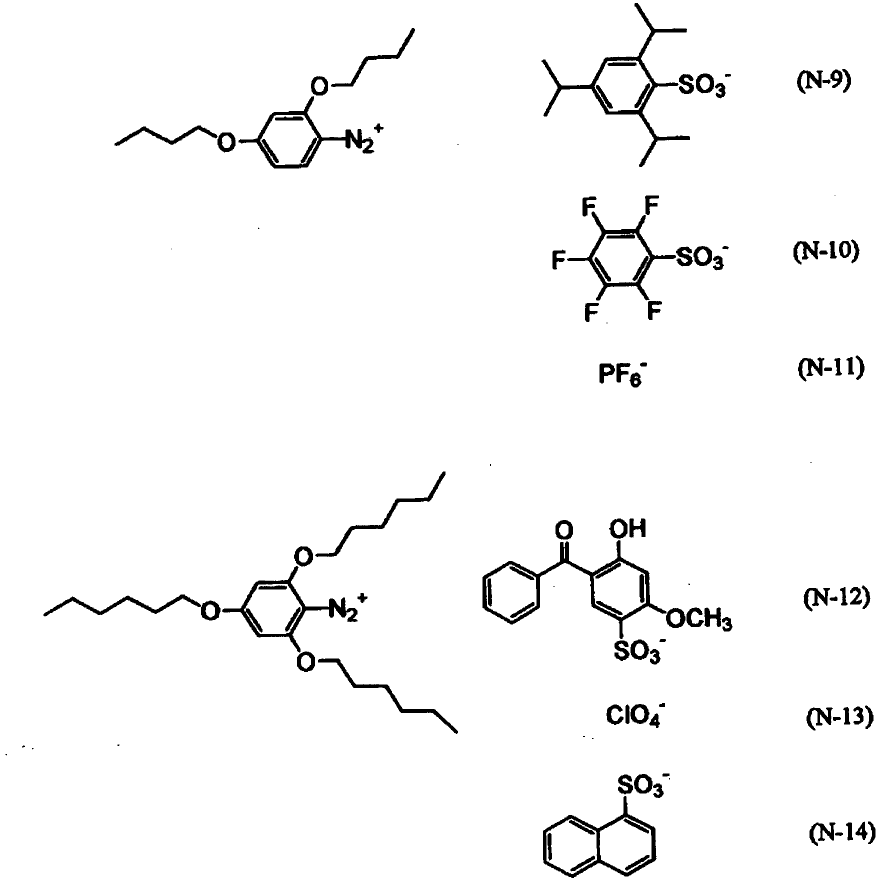

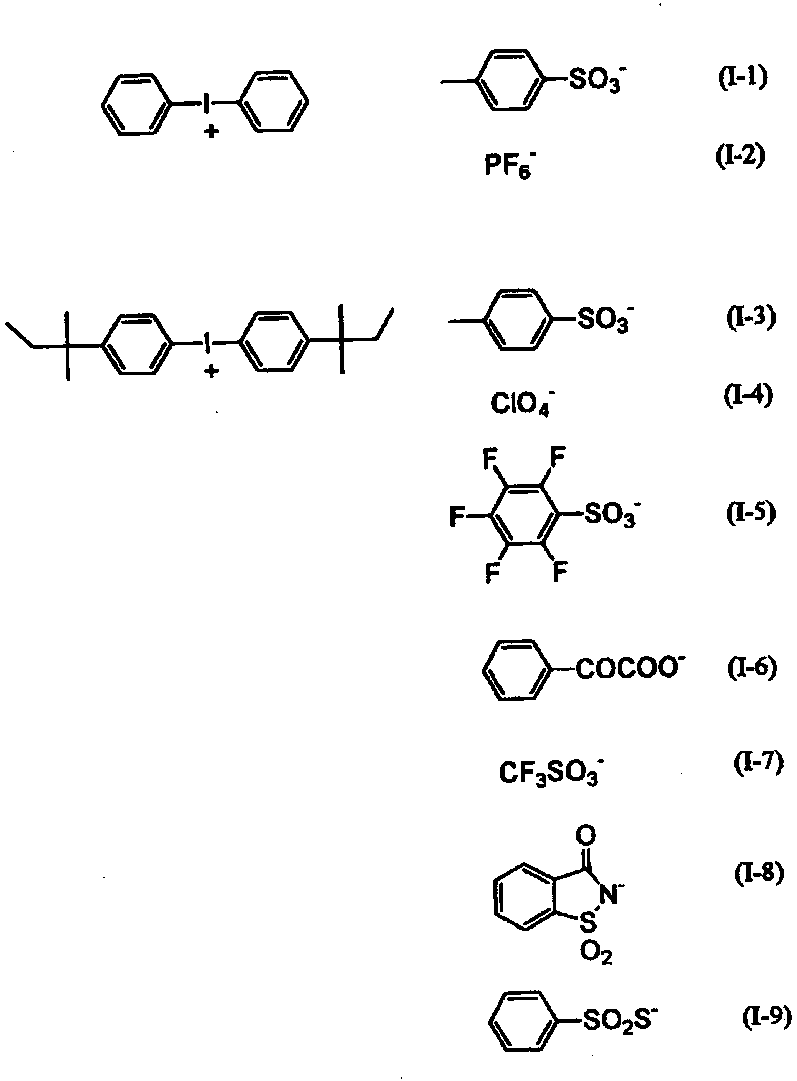

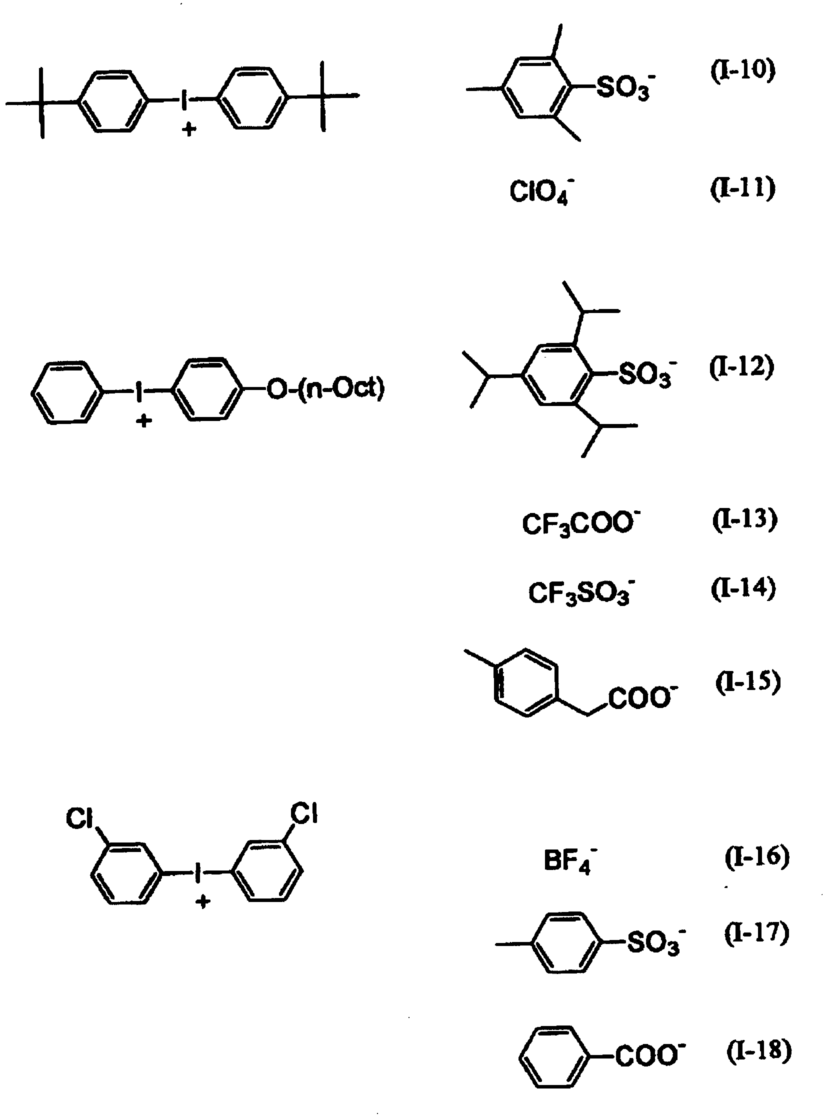

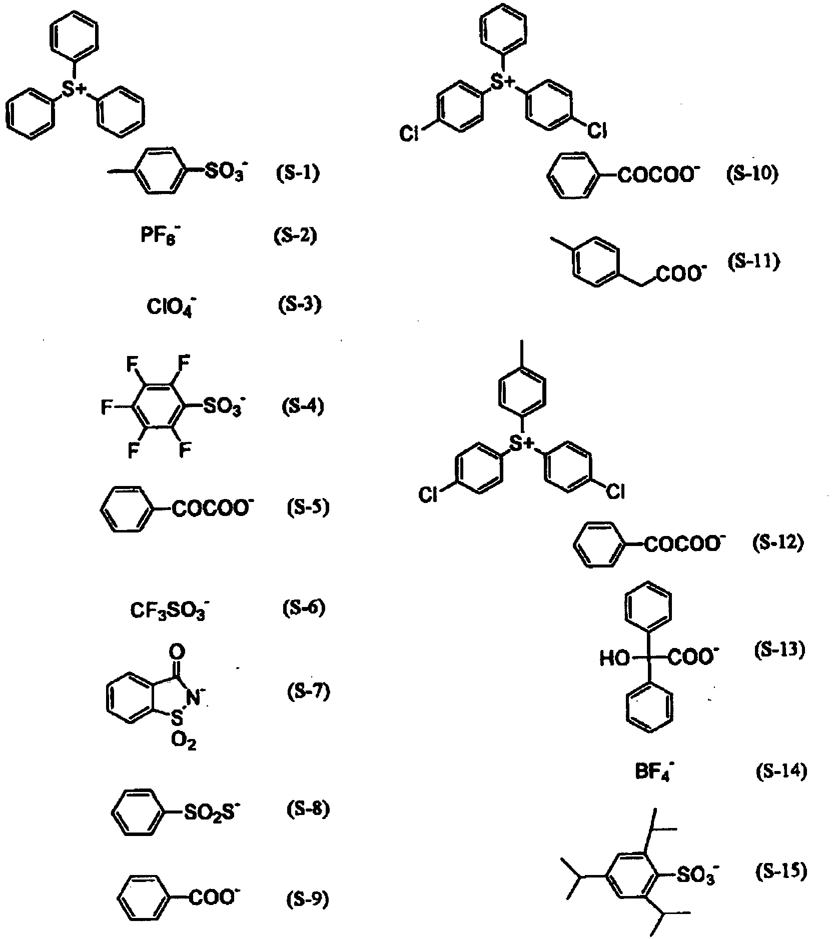

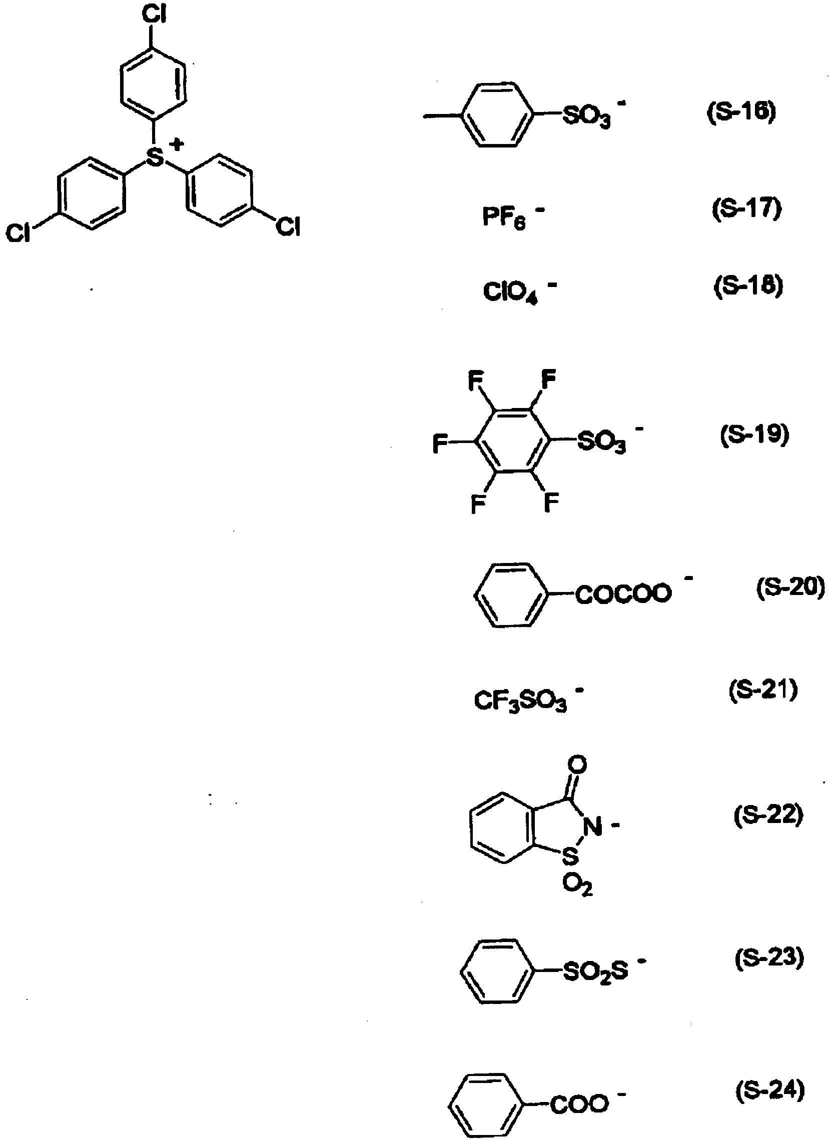

The polymerization initiator is not limited to those described above, but particularly in view of reactivity and stability, triazine-based initiators, organohalogen compounds, oxime ester compounds, diazonium salts, iodonium salts and sulfonium salts are more preferred because these generate a large amount of radical by the exposure in a short time.

The polymerization initiator in the system of such a triazine-based initiator, organohalogen compound, oxime ester compound, diazonium salt, iodonium salt or sulfonium salt is preferably used in combination with a sensitizing dye, because the photopolymerization rate can be increased by the combination use with a sensitizing dye.

Specific examples of the sensitizing dye include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-tert-butyl-9,10-anthraquinone, 2,6-dichloro-9,10-anthraquinone, xanthone, 2-methylxanthone, 2-methoxyxanthone, thioxanthone, benzyl, dibenzylacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone and benzanthrone.

Furthermore, preferred examples of the sensitizing dye for use in the present invention include compounds described in JP-B-51-48516, which are represented by formula (I):

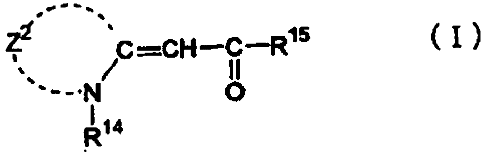

In formula (I), R¹⁴ represents an alkyl group (e.g., methyl, ethyl, propyl) or a substituted alkyl group (e.g., 2-hydroxyethyl, 2-methoxyethyl, carboxymethyl, 2-carboxyethyl). R¹⁵ represents an alkyl group (e.g., methyl, ethyl) or an aryl group (e.g., phenyl, p-hydroxyphenyl, naphthyl, thienyl).

Z² represents a nonmetallic atom group necessary for forming a nitrogen-containing heterocyclic nucleus usually used in cyanine dyes, such as benzothiazoles (e.g., benzothiazole, 5-chlorobenzothiazole, 6-chlorothiazole), naphthothiazoles (e.g., α-naphthothiazole, β-naphthothiazole), benzoselenazoles (e.g., benzoselenazole, 5-chlorobenzoselenazole, 6-methoxybenzoselenazole), naphthoselenazoles (e.g., α-naphthoselenazole, β-naphthoselenazole), benzoxazoles (e.g., benzoxazole, 5-methylbenzoxazole, 5-phenylbenzoxazole) and naphthoxazoles (e.g., α-naphthoxazole, β-naphthoxazole).

Specific examples of the compound represented by formula (I) include those having a chemical structure constituted by combining these Z², R¹⁴ and R¹⁵. Many of such compounds are present as a known substance and therefore, the compound may be appropriately selected and used from those known substances. Other preferred examples of the sensitizer for use in the present invention include merocyanine dyes described in JP-B-5-47095 and ketocoumarin-based compounds represented by the following formula (II): 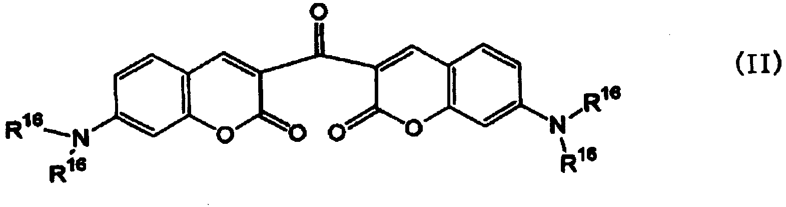 wherein R¹⁶ represents an alkyl group such as methyl group and ethyl group.

In addition, merocyanine-based dyes described in JP-A-2000-147763 may also be used as the sensitizing dye. Specific examples thereof include the following compounds.

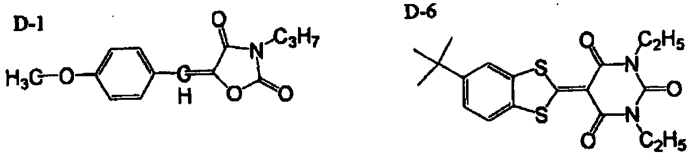

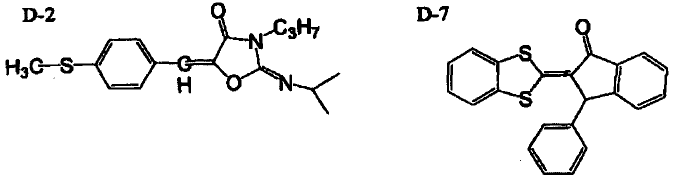

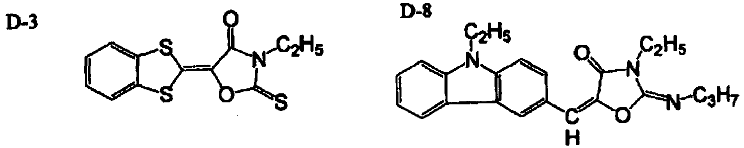

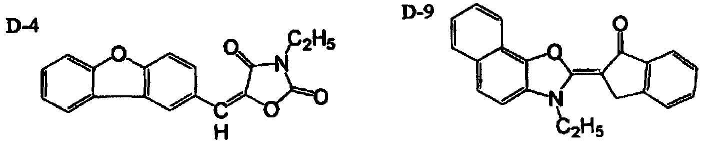

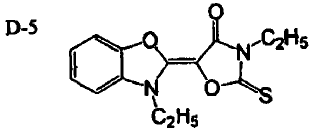

The polymerization initiator and sensitizing dye each can be added at a ratio of preferably 0.1 to 50 mass%, more preferably from 0.5 to 30 mass%, still more preferably from 0.8 to 20 mass%, based on all solid contents constituting the image recording layer. Within this range, good sensitivity and good antistaining property of the non-image area at the printing can be obtained. One of these polymerization initiators may be used alone, or two or more thereof may be used in combination. Also, the polymerization initiator may be added together with other components in the same layer or may be added to a layer separately provided.

In the present invention, when the imagewise exposure is performed by using a light source of emitting infrared rays, the image recording layer of the lithographic printing plate precursor preferably uses the polymerization initiator in combination with an infrared absorbent instead of the sensitizing dye. The infrared absorbent in general has a function of converting the absorbed infrared ray into heat and by the effect of heat generated, the polymerization initiator can be thermally decomposed and generate a radical. The infrared absorbent for use in the present invention is a dye or pigment having an absorption maximum at a wavelength of 760 to 1,200 nm.

As for the dye, commercially available dyes and known dyes described in publications, for example, in Senryo Binran (Handbook of Dyes), compiled by Yuki Gosei Kagaku Kyokai (1970), may be used. Specific examples thereof include dyes such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Preferred examples of the dye include cyanine dyes described in JP-A-58-125246, JP-A-59-84356 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiapyrylium salts described in U.S. Patent 4,283,475, and pyrylium compounds described in JP-B-5-13514 and JP-B-5-19702 may also be preferably used. Other preferred examples of the dye include near infrared absorbing dyes represented by formulae (I) and (II) of U.S. Patent 4,756,993.

Among these dyes, particularly preferred are cyanine dye, squarylium dye, pyrylium salt, nickel thiolate complex and indolenine cyanine dye, more preferred are cyanine dye and indolenine cyanine dye, still more preferred is a cyanine dye, for example, represented by the following formula (III):

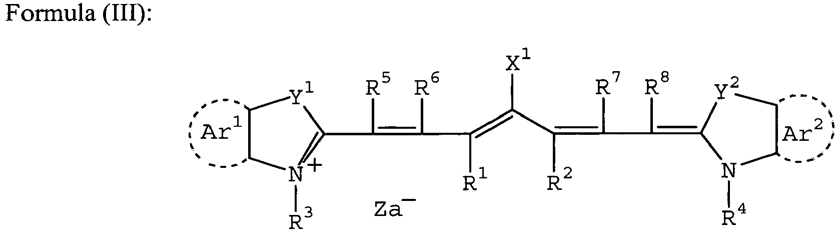

In formula (III), X¹ represents a hydrogen atom, a halogen atom, -NPh₂, X²-L¹ or a group shown below (wherein X² represents an oxygen atom, a nitrogen atom or a sulfur atom, L¹ represents a hydrocarbon group having from 1 to 12 carbon atoms, an aromatic ring having a heteroatom, or a hydrocarbon group having from 1 to 12 carbon atoms and containing a heteroatom (the heteroatom as used herein indicates N, S, O, a halogen atom or Se), Xₐ⁻ has the same definition as Za⁻ described later, and R^{a} represents a substituent selected from a hydrogen atom, an alkyl group, an aryl group, a substituted or unsubstituted amino group and a halogen atom):

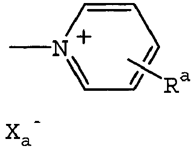

R¹ and R² each independently represents a hydrocarbon group having from 1 to 12 carbon atoms. In view of storage stability of the coating solution for the recording layer, R¹ and R² each is preferably a hydrocarbon group having 2 to more carbon atoms, and R¹ and R² are more preferably combined with each other to form a 5- or 6-membered ring.

Ar¹ and Ar² may be the same or different and each represents an aromatic hydrocarbon group which may have a substituent. Preferred examples of the aromatic hydrocarbon group include a benzene ring and a naphthalene ring. Preferred examples of the substituent include a hydrocarbon group having 12 or less carbon atoms, a halogen atom and an alkoxy group having 12 or less carbon atoms. Y¹ and Y² may be the same or different and each represents a sulfur atom or a dialkylmethylene group having 12 or less carbon atoms. R³ and R⁴ may be the same or different and each represents a hydrocarbon group having 20 or less carbon atoms, which may have a substituent. Preferred examples of the substituent include an alkoxy group having 12 or less carbon atoms, a carboxyl group and a sulfo group. R⁵, R⁶, R⁷ and R⁸ may be the same or different and each represents a hydrogen atom or a hydrocarbon group having 12 or less carbon atoms, and in view of availability of the raw material, preferably a hydrogen atom. Za⁻ represents a counter anion, but when the cyanine dye represented by formula (III) has an anionic substituent in its structure and neutralization of electric charge is not necessary, Za⁻ is not present. In view of storage stability of the coating solution for the recording layer, Za⁻ is preferably halogen ion, perchlorate ion, tetrafluoroborate ion, hexafluorophosphate ion or sulfonate ion, more preferably perchlorate ion, hexafluorophosphate ion or arylsulfonate ion.

Specific examples of the cyanine dye represented by formula (III), which can be suitably used in the present invention, include those described in paragraphs [0017] to [0019] of JP-A-2001-133969.

Other preferred examples include specific indolenine cyanine dyes described in JP-A-2002-278057.

As for the pigment used in the present invention, commercially available pigments and pigments described in Color Index (C.I.) Binran (C.I. Handbook), Saishin Ganryo Binran (Handbook of Newest Pigments), compiled by Nippon Ganryo Gijutsu Kyokai (1977), Saishin Ganryo Oyo Gijutsu (Newest Pigment Application Technology), CMC Shuppan (1986), and Insatsu Ink Gijutsu (Printing Ink Technology), CMC Shuppan (1984) can be used.

The kind of pigment includes black pigment, yellow pigment, orange pigment, brown pigment, red pigment, violet pigment, blue pigment, green pigment, fluorescent pigment, metal powder pigment and polymer bond dye. Specific examples of the pigment which can be used include insoluble azo pigments, azo lake pigments, condensed azo pigments, chelate azo pigments, phthalocyanine-based pigments, anthraquinone-based pigments, perylene- or perynone-based pigments, thioindigo-based pigments, quinacridone-based pigments, dioxazine-based pigments, isoindolinone-based pigments, quinophthalone-based pigments, dyed lake pigments, azine pigments, nitroso pigments, nitro pigments, natural pigments, fluorescent pigments, inorganic pigments and carbon black. Among these pigments, carbon black is preferred.

These pigments may or may not be surface-treated before use. Examples of the method for surface treatment include a method of coating the surface with resin or wax, a method of attaching a surfactant, and a method of bonding a reactive substance (for example, a silane coupling agent, an epoxy compound or an isocyanate) to the pigment surface. These surface-treatment methods are described in Kinzoku Sekken no Seishitsu to Oyo (Properties and Application of Metal Soap), Saiwai Shobo, Insatsu Ink Giiutsu (Printing Ink Technology), CMC Shuppan (1984), and Saishin Ganryo Oyo Gijutsu (Newest Pigment Application Technology), CMC Shuppan (1986).

The particle diameter of the pigment is preferably from 0.01 to 10 µm, more preferably from 0.05 to 1 µm, still more preferably from 0.1 to 1 µm. Within this range, good stability of the pigment dispersion in the coating solution for the image recording layer and good uniformity of the image recording layer can be obtained.

As for the dispersion method of the pigment, a known dispersion technique used in the production of ink or toner may be used. Examples of the dispersing machine include ultrasonic disperser, sand mill, attritor, pearl mill, super-mill, ball mill, impeller, disperser, KD mill, colloid mill, dynatron, three-roll mill and pressure kneader. These are described in detail in Saishin Ganryo Oyo Gijutsu (Newest Pigment Application Technology), CMC Shuppan (1986).

The infrared absorbent is preferably added to the image recording layer in a required minimum amount so as to prevent a side reaction capable of inhibiting the polymerization.

The infrared absorbent can be added at a ratio of 0.001 to 50 mass%, preferably from 0.005 to 30 mass%, more preferably from 0.01 to 10 mass%, based on the entire solid content of the image recording layer. When the ratio is in this range, high sensitivity can be obtained without causing adverse effect on the uniformity or film strength of the image recording layer.

### <(B) Polymerizable Compound>

The polymerizable compound which can be used in the present invention is an addition-polymerizable compound having at least one ethylenically unsaturated double bond and is selected from compounds having at least one, preferably two or more, ethylenically unsaturated bond(s). Such compounds are widely known in this industrial field and these known compounds can be used in the present invention without any particular limitation. These compounds have a chemical mode such as monomer, prepolymer (that is, dimer, trimer or oligomer) or a mixture or copolymer thereof. Examples of the monomer and its copolymer include unsaturated carboxylic acids (e.g., acrylic acid, methacrylic acid, itaconic acid, crotonic acid, isocrotonic acid, maleic acid), and esters and amides thereof. Among these, preferred are esters of an unsaturated carboxylic acid with an aliphatic polyhydric alcohol compound, and amides of an unsaturated carboxylic acid with an aliphatic polyvalent amine compound. Also, addition reaction products of an unsaturated carboxylic acid ester or amide having a nucleophilic substituent such as hydroxyl group, amino group or mercapto group with a monofunctional or polyfunctional isocyanate or epoxy, and dehydrating condensation reaction products with a monofunctional or polyfunctional carboxylic acid may be suitably used. Furthermore, addition reaction products of an unsaturated carboxylic acid ester or amide having an electrophilic substituent such as isocyanate group or epoxy group with a monofunctional or polyfunctional alcohol, amine or thiol, and displacement reaction products of an unsaturated carboxylic acid ester or amide having a desorptive substituent such as halogen group or tosyloxy group with a monofunctional or polyfunctional alcohol, amine or thiol may also be suitably used. Also, compounds where the unsaturated carboxylic acid of the above-described compounds is replaced by an unsaturated phosphonic acid, styrene, vinyl ether or the like, may be used.

Specific examples of the ester monomer of an aliphatic polyhydric alcohol compound with an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, polyester acrylate oligomer and isocyanuric acid EO-modified triacrylate.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)-phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate. Examples of the crotonic acid ester include ethylene glycol dicrotonate, tetramethylene glycol dicrotonate, pentaerythritol dicrotonate and sorbitol tetradicrotonate. Examples of the isocrotonic acid ester include ethylene glycol diisocrotonate, pentaerythritol diisocrotonate and sorbitol tetraisocrotonate. Examples of the maleic acid ester include ethylene glycol dimaleate, triethylene glycol dimaleate, pentaerythritol dimaleate and sorbitol tetramaleate.

Other examples of the ester include aliphatic alcohol-based esters described in JP-B-51-47334 and JP-A-57-196231, those having an aromatic skeleton described in JP-A-59-5240, JP-A-59-5241 and JP-A-2-226149, and those containing an amino group described in JP-A-1-165613. These ester monomers may also be used as a mixture.

Specific examples of the amide monomer of an aliphatic polyvalent amine compound with an unsaturated carboxylic acid include methylenebisacrylamide, methylene-bismethacrylamide, 1,6-hexamethylenebisacrylamide, 1,6-hexamethylenebismethacrylamide, diethylenetriaminetrisacrylamide, xylylenebisacrylamide and xylylenebismethacrylamide. Other preferred examples of the amide-type monomer include those having a cyclohexylene structure described in JP-B-54-21726.

A urethane-based addition-polymerizable compound produced by using an addition reaction of isocyanate with a hydroxyl group is also preferred and specific examples thereof include vinyl urethane compounds having two or more polymerizable vinyl groups within one molecule described in JP-B-48-41708, which are obtained by adding a vinyl monomer having a hydroxyl group represented by the following formula (a) to a polyisocyanate compound having two or more isocyanate groups within one molecule:

CH₂=C(R₄)COOCH₂CH(R₅)OH (a)

(wherein R₄ and R₅ each represents H or CH₃).

Also, urethane acrylates described in JP-A-51-37193, JP-B-2-32293 and JP-B-2-16765, and urethane compounds having an ethylene oxide-type skeleton described in JP-B-58-49860, JP-B-56-17654, JP-B-62-39417 and JP-B-62-39418 are also suitably used. Furthermore, when addition-polymerizable compounds having an amino or sulfide structure within the molecule described in JP-A-63-277653, JP-A-63-260909 and JP-A-1-105238 are used, a photopolymerizable composition having very excellent photosensitization speed can be obtained.

Other examples include polyfunctional acrylates and methacrylates such as polyester acrylates described in JP-A-48-64183, JP-B-49-43191 and JP-B-52-30490 and epoxy acrylates obtained by reacting an epoxy resin with a (meth)acrylic acid. In addition, specific unsaturated compounds described in JP-B-46-43946, JP-B-1-40337 and JP-B-1-40336, and vinyl phosphonic acid-based compounds described in JP-A-2-25493 may be used. In some cases, structures containing a perfluoroalkyl group described in JP-A-61-22048 are suitably used. Furthermore, those described as a photocurable monomer or oligomer in Adhesion, Vol. 20, No. 7, pp. 300-308 (1984) may also be used.

Details of the use method of these polymerizable compounds, such as structure, sole or combination use and amount added, can be freely selected in accordance with the designed performance of the final lithographic printing plate precursor and, for example, may be selected from the following standpoints.

In view of sensitivity, a structure having a large unsaturated group content per one molecule is preferred and in most cases, a bifunctional or greater functional compound is preferred. For increasing the strength of image part, namely, cured layer, a trifunctional or greater functional compound is preferred. Also, a method of controlling both sensitivity and strength by using a combination of compounds differing in the functional number or in the polymerizable group (for example, an acrylic acid ester, a methacrylic acid ester, a styrene-based compound or a vinyl ether-based compound) is effective.

The selection and use method of the polymerizable compound are important factors also for the compatibility and dispersibility with other components (e.g., binder polymer, initiator, colorant) in the image recording layer. For example, the compatibility may be improved in some cases by using a low purity compound or using two or more compounds in combination. Also, a specific structure may be selected for the purpose of improving the adhesion to the substrate, protective layer which is described later, or the like.

The polymerizable compound is preferably used in an amount of 5 to 80 mass%, more preferably from 25 to 75 mass%, based on all solid contents constituting the image recording layer. Also, these polymerizable compounds may be used individually or in combination of two or more thereof. Other than these, as for the use method of the polymerizable compound, appropriate structure, formulation and amount added can be freely selected by taking account of the degree of polymerization inhibition due to oxygen, resolution, fogging, change in refractive index, surface tackiness and the like. Depending on the case, a layer structure or coating method such as undercoat and overcoat can also be employed.

### <Other Components of Image Recording Layer>

The image recording layer of the present invention may further contain additives as needed, such as binder polymer, surfactant, colorant, printing-out agent, thermopolymerization inhibitor, higher fatty acid derivative, plasticizer, inorganic fine particle and low molecule hydrophilic compound. These additives are described below.

### <Binder Polymer>

In the present invention, a binder polymer may be used for enhancing the film strength or film property of the image recording layer and for elevating the on-press developability. As for the binder polymer, conventionally known binder polymers can be used without limitation, and a linear organic polymer having a film property is preferred. Examples of such a binder polymer include acrylic resin, polyvinyl acetal resin, polyurethane resin, polyurea resin, polyimide resin, polyamide resin, epoxy resin, methacrylic resin, polystyrene-based resin, novolak-type phenol-based resin, polyester resin, synthetic rubber and natural rubber.

The binder polymer may have a crosslinking property so as to enhance the film strength in the image part. The crosslinking property may be imparted to the binder polymer by introducing a crosslinking functional group such as ethylenically unsaturated bond into the main or side chain of the polymer. The crosslinking functional group may be introduced by copolymerization.

Examples of the polymer having an ethylenically unsaturated bond in the main chain of the molecule include poly-1,4-butadiene and poly-1,4-isoprene.

Examples of the polymer having an ethylenically unsaturated bond in the side chain of the molecule include polymers which are a polymer of acrylic or methacrylic acid ester or amide and in which the ester or amide residue (R in -COOR or -CONHR) has an ethylenically unsaturated bond.

Examples of the residue (R above) having an ethylenically unsaturated bond include - (CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl, aryl, alkoxy or aryloxy group having from 1 to 20 carbon atoms, R¹ and R² or R³ may combine with each other to form a ring, n represents an integer of 1 to 10, and X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅,-CH₂CH₂OCOCH=CH-C₆H₅, -CH₂CH₂-NHCOO-CH₂CH=CH₂ and CH₂CH₂O-X (wherein X represents a dicyclopentadienyl residue).

Specific examples of the amide residue include -CH₂CH=CH₂, -CH₂CH₂-Y (wherein Y represents a cyclohexene residue) and -CH₂CH₂-OCO-CH=CH₂.

In the binder polymer having a crosslinking property, for example, a free radical (a polymerization initiating radical or a radical grown in the process of polymerization of a polymerizable compound) is added to the crosslinking functional group to cause addition-polymerization between polymers directly or through a polymerization chain of the polymerizable compound, as a result, crosslinking is formed between polymer molecules and thereby curing is effected. Alternatively, an atom (for example, a hydrogen atom on the carbon atom adjacent to the functional crosslinking group) in the polymer is withdrawn by a free radical to produce a polymer radical and the polymer radicals combine with each other to form crosslinking between polymer molecules, thereby effecting curing.

The content of the crosslinking group (content of radical-polymerizable unsaturated double bond determined by iodine titration) in the binder polymer is preferably from 0.1 to 10.0 mmol, more preferably from 1.0 to 7.0 mmol, most preferably from 2.0 to 5.5 mmol, per g of the binder polymer. Within this range, good sensitivity and good storage stability can be obtained.

In view of on-press developability of the image recording layer in the unexposed area, the binder polymer preferably has high solubility or dispersibility for an ink and/or a fountain solution.

The binder polymer is preferably lipophilic for enhancing the solubility or dispersibility for ink, and the binder polymer is preferably hydrophilic for enhancing the solubility or dispersibility for a fountain solution. Therefore, in the present invention, it is also effective to use a lipophilic binder polymer and a hydrophilic binder polymer in combination.

Preferred examples of the hydrophilic binder polymer include those having a hydrophilic group such as hydroxy group, carboxyl group, carboxylate group, hydroxyethyl group, polyoxyethyl group, hydroxypropyl group, polyoxypropyl group, amino group, aminoethyl group, aminopropyl group, ammonium group, amide group, carboxymethyl group, sulfonic acid group and phosphoric acid group.

Specific examples thereof include gum arabic, casein, gelatin, starch derivatives, carboxymethyl cellulose and sodium salt thereof, cellulose acetate, sodium alginate, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetates having a hydrolysis degree of 60 mol% or more, preferably 80 mol% or more, polyvinyl formal, polyvinyl butyral, polyvinylpyrrolidone, homopolymers and polymers of acrylamide, homopolymers and copolymers of methacrylamide, homopolymers and copolymers of N-methylolacrylamide, polyvinylpyrrolidone, alcohol-soluble nylons, and polyethers of 2,2-bis-(4-hydroxyphenyl)-propane with epichlorohydrin.

The binder polymer preferably has a mass average molecular weight of 5,000 or more, more preferably from 10,000 to 300,000. The number average molecular weight thereof is preferably 1,000 or more, more preferably from 2,000 to 250,000. The polydispersity (mass average molecular weight/number average molecular weight) is preferably from 1.1 to 10.

The binder polymer may be any polymer such as random polymer, block polymer or graft polymer, but is preferably a random polymer.

The binder polymer can be synthesized by a conventionally know method. Examples of the solvent used in the synthesis include tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, methyl lactate, ethyl lactate, dimethylsulfoxide and water. These solvents are used individually or as a mixture of two or more thereof.

As for the radical polymerization initiator used in the synthesis of the binder polymer, known compounds such as azo-type initiator and peroxide initiator can be used.

The binder polymers may be used individually or as a mixture of two or more thereof.

The binder polymer content is preferably from 10 to 90 mass%, more preferably from 20 to 80 mass%, still more preferably from 30 to 70 mass%, based on the entire solid content of the image recording layer. Within this range, good strength of image area and good image-forming property can be obtained.

The polymerizable compound (B) and the binder polymer are preferably used in amounts of giving a mass ratio of 1/9 to 7/3.

### <Surfactant>

In the present invention, a surfactant is preferably used in the image recording layer so as to accelerate the on-press development at the initiation of printing and enhance the coated surface state. The surfactant includes a nonionic surfactant, an anionic surfactant, a cationic surfactant, an amphoteric surfactant, a fluorine-containing surfactant and the like. The surfactants may be used individually or in combination of two or more thereof.

The nonionic surfactant for use in the present invention is not particularly limited and a conventionally known nonionic surfactant can be used. Examples thereof include polyoxyethylene alkyl ethers, polyoxyethylene alkylphenyl ethers, polyoxyethylene polystyrylphenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamines, triethanolamine fatty acid esters, trialkylamine oxides, polyethylene glycol, and copolymers of polyethylene glycol and polypropylene glycol.

The anionic surfactant for use in the present invention is not particularly limited and a conventionally known anionic surfactant can be used. Examples thereof include fatty acid salts, abietates, hydroxyalkanesulfonates, alkanesulfonates, dialkylsulfosuccinic ester salts, linear alkylbenzenesulfonates, branched alkylbenzenesulfonates, alkylnaphthalenesulfonates, alkyl-phenoxypolyoxyethylenepropylsulfonates, polyoxyethylenealkylsulfophenyl ether salts, N-methyl-N-oleyltaurine sodium salts, monoamide disodium N-alkylsulfosuccinates, petroleum sulfonates, sulfated beef tallow oils, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified products of styrene/maleic anhydride copolymer, partially saponified products of olefin/maleic anhydride copolymer, and naphthalenesulfonate formalin condensates.

The cationic surfactant for use in the present invention is not particularly limited and a conventionally known cationic surfactant can be used. Examples thereof include alkylamine salts, quaternary ammonium salts, polyoxyethylenealkylamine salts and polyethylene polyamine derivatives.

The amphoteric surfactant for use in the present invention is not particularly limited and a conventionally known amphoteric surfactant can be used. Examples thereof include carboxybetaines, aminocarboxylic acids, sulfobetaines, aminosulfuric esters and imidazolines.

The term "polyoxyethylene" in the above-described surfactants can be instead read as "polyoxyalkylene" such as polyoxymethylene, polyoxypropylene and polyoxybutylene, and these surfactants can also be used in the present invention.

The surfactant is more preferably a fluorine-containing surfactant containing a perfluoroalkyl group within the molecule. This fluorine-containing surfactant includes an anionic type such as perfluoroalkylcarboxylate, perfluoroalkylsulfonate and perfluoroalkylphosphoric ester; an amphoteric type such as perfluoroalkylbetaine; a cationic type such as perfluoroalkyltrimethylammonium salt; and a nonionic type such as perfluoroalkylamine oxide, perfluoroalkyl ethylene oxide adduct, oligomer containing a perfluoroalkyl group and a hydrophilic group, oligomer containing a perfluoroalkyl group and a lipophilic group, oligomer containing a perfluoroalkyl group, a hydrophilic group and a lipophilic group, and urethane containing a perfluoroalkyl group and a lipophilic group. In addition, fluorine-containing surfactants described in JP-A-62-170950, JP-A-62-226143 and JP-A-60-168144 may also be suitably used.

The surfactants can be used individually or in combination of two or more thereof.

The surfactant content is preferably from 0.001 to 10 mass%, more preferably from 0.01 to 7 mass%, based on the entire solid content of the image recording layer.

### <Colorant>

In the present invention, various compounds may be further added, if desired, in addition to the above-described additives. For example, a dye having large absorption in the visible light region can be used as a colorant of the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industry Co., Ltd.), Victoria Pure Blue, Crystal Violet (CI42555), Methyl Violet (CI42535), Ethyl Violet, Rhodamine B (CI145170B), Malachite Green (CI42000), Methylene Blue (CI52015), and dyes described in JP-A-62-293247. Also, pigments such as phthalocyanine-based pigment, azo-based pigment, carbon black and titanium oxide may be suitably used.

The colorant is preferably added, because the image area and the non-image area after image formation can be clearly distinguished. The amount of the colorant added is preferably from 0.01 to 10 mass% based on the entire solid content of the image recording material.

### <Printing-Out Agent>

In the image recording layer of the present invention, a compound of undergoing change in the color by the effect of an acid or a radical can be added so as to produce a print-out image. As such a compound, various dyes such as diphenylmethane-based dye, triphenylmethane-based dye, thiazine-based dye, oxazine-based dye, xanthene-based dye, anthraquinone-based dye, iminoquinone-based dye, azo-based dye and azomethine-based dye are effective.

Specific examples thereof include dyes such as Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH [produced by Hodogaya Chemical Co., Ltd.], Oil Blue #603 [produced by Orient Chemical Industry Co., Ltd.], Oil Pink #312 [produced by Orient Chemical Industry Co., Ltd.], Oil Red 5B [produced by Orient Chemical Industry Co., Ltd.], Oil Scarlet #308 [produced by Orient Chemical Industry Co., Ltd.], Oil Red OG [produced by Orient Chemical Industry Co., Ltd.], Oil Red RR [produced by Orient Chemical Industry Co., Ltd.], Oil Green #502 [produced by Orient Chemical Industry Co., Ltd.], Spiron Red BEH Special [produced by Hodogaya Chemical Co., Ltd.], m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3 -methyl-4-p-diethylaminophenylimino-5-pyrazolone and 1-β-naphthyl-4-p-diethylaminophenylimino-5-pyrazolone, and leuco dyes such as p,p',p"-hexamethyltriaminotriphenyl methane (Leuco Crystal Violet) and Pergascript Blue SRB (produced by Ciba Geigy).

Other suitable examples include leuco dyes known as a material for heat-sensitive or pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino)fluorane, 3,6-dimethoxyfluorane, 3-(N,N-diethylamino)-5-methyl-7-(N,N-dibenzylamino)-fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide and 3-(4-diethylaminophenyl)-3-(1-ethyl-2-methylindol-3-yl)phthalide.

The dye of undergoing change in the color by the effect of an acid or a radical is preferably added in an amount of 0.01 to 15 mass% based on the solid content of the image recording layer.

### <Thermopolymerization Inhibitor>

In the image recording layer of the present invention, a small amount of a thermopolymerization inhibitor may be added in addition to the above-described polymerization inhibitor precursor so as to prevent unnecessary thermopolymerization of (C) the radical polymerizable compound during the production or storage of the image recording layer.

Examples of the thermopolymerization inhibitor include the radical polymerization inhibitors described above for the compound capable of generating, when heated, a chemical species capable of inhibiting a polymerization reaction.

The amount of the thermopolymerization inhibitor added is preferably about 5 mass% or less based on the entire solid content of the image recording layer.

### <Higher Fatty Acid Derivative, etc.>

In the image recording layer of the present invention, a higher fatty acid derivative such as behenic acid or behenic acid amide may be added to localize on the surface of the image recording layer during drying after coating so as to prevent polymerization inhibition by oxygen. The amount of the higher fatty acid derivative added is preferably from about 0.1 to about 10 mass% based on the entire solid content of the image recording layer.

### <Plasticizer>

The image recording layer of the present invention may contain a plasticizer for enhancing the on-press developability.

Suitable examples of the plasticizer include phthalic acid esters such as dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate and diallyl phthalate; glycol esters such as dimethyl glycol phthalate, ethyl phthalylethyl glycolate, methyl phthalylethyl glycolate, butyl phthalylbutyl glycolate and triethylene glycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate; polyglycidyl methacrylate, triethyl citrate, glycerin triacetyl ester and butyl laurate.

The plasticizer content is preferably about 30 mass% or less based on the entire solid content of the image recording layer.

### <Inorganic Fine Particle>

The image recording layer of the present invention may contain an inorganic fine particle so as to elevate the cured film strength in the image area and enhance the on-press developability of the non-image area.

Suitable examples of the inorganic fine particle include silica, alumina, magnesium oxide, titanium oxide, magnesium carbonate, calcium alginate and a mixture thereof. Such an inorganic fine particle can be used for strengthening the film or roughening the surface to enhance the adhesion at the interface, even if it has no light-to-heat converting property.

The average particle diameter of the inorganic fine particle is preferably from 5 nm to 10 µm, more preferably from 0.5 to 3 µm. Within this range, the inorganic particles are stably dispersed in the image recording layer, so that the image recording layer can maintain sufficiently high film strength and the non-image area formed can have excellent hydrophilicity and exhibit antistaining property at printing.

Such an inorganic fine particle is easily available on the market as a colloidal silica dispersion or the like.

The inorganic fine particle content is preferably 20 mass% or less, more preferably 10 mass% or less, based on the entire solid content of the image recording layer.

### <Low-Molecular Hydrophilic Compound>

The image recording layer of the present invention may contain a hydrophilic low-molecular compound so as to enhance the on-press developability. Examples of the hydrophilic low-molecular compound include, as a water-soluble organic compound, glycols and ether or ester derivatives thereof, such as ethylene glycol, diethylene glycol, triethylene glycol, propylene glycol, dipropylene glycol and tripropylene glycol; polyhydroxys such as glycerin and pentaerythritol; organic amines and salts thereof, such as triethanolamine, diethanolamine and monoethanolamine; organic sulfonic acids and salts thereof, such as toluenesulfonic acid and benzenesulfonic acid; organic phosphonic acids and salts thereof, such as phenylphosphonic acid; and organic carboxylic acids and salts thereof, such as tartaric acid, oxalic acid, citric acid, malic acid, lactic acid, gluconic acid and amino acids.

### <Formation of Image Recording Layer>

In the present invention, the method for incorporating these image recording layer-constituting components into the image recording layer can take several embodiments. One embodiment is a molecular dispersion-type image recording layer formed by dissolving those constituent components in an appropriate solvent and coating the obtained coating solution described, for example, in JP-A-2002-287334. Another embodiment is a microcapsule-type image recording layer formed by enclosing all or a part of the constituent components in a microcapsule and incorporating the microcapsule into the image recording layer described, for example, in JP-A-2001-277740 and JP-A-2001-277742. In the case of the microcapsule-type image recording layer, the constituent components may be incorporated also outside the microcapsule. A preferred embodiment of the microcapsule-type image recording layer is to enclose hydrophobic constituent components in a microcapsule and incorporate hydrophilic constituent components outside the microcapsule. In order to obtain more excellent on-press developability, the image recording layer is preferably a microcapsule-type image recording layer.

For microencapsulating the constituent components of the image recording layer, known methods can be used. Examples of the method for producing a microcapsule include, but are not limited to, a method utilizing coacervation described in U.S. Patents 2,800,457 and 2,800,458, a method utilizing interfacial polymerization described in U.S. Patent 3,287,154, JP-B-38-19574 and JP-B-42-446, a method utilizing polymer precipitation described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamine-formaldehyde resin and hydroxy cellulose described in U.S. Patent 4,025,445, an *in situ* method utilizing monomer polymerization described in JP-B-36-9163 and JP-A-51-9079, a spray drying method described in British Patent 930,422 and U.S. Patent 3,111,407, and an electrolytic dispersion cooling method described in British Patents 952,807 and 967,074.

The microcapsule wall for use in the present invention preferably has a three-dimensionally crosslinked structure and has a property of swelling with a solvent. From this standpoint, the wall material of microcapsule is preferably polyurea, polyurethane, polyester, polycarbonate, polyamide or a mixture thereof, more preferably polyurea or polyurethane. Also, the above-described compound having a crosslinking functional group such as ethylenically unsaturated bond, which can be introduced into the binder polymer, may be introduced into the microcapsule wall.

The average particle diameter of the microcapsule is preferably from 0.01 to 3.0 µm, more preferably from 0.05 to 2.0 µm, still more preferably from 0.10 to 1.0 µm. Within this range, good resolution and good aging stability can be obtained.

The image recording layer of the present invention is formed by dispersing or dissolving the above-described necessary components in a solvent and coating the prepared coating solution. Examples of the solvent used here include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyl lactone, toluene and water. These solvents are used individually or in combination. The solid content concentration of the coating solution is preferably from 1 to 50 mass%.

The image recording layer of the present invention may also be formed by dispersing or dissolving the same or different components described above in the same or different solvents to prepare a plurality of coating solutions and repeating the coating and drying multiple times.

The coated amount (solid content) of the image recording layer obtained on the support after coating and drying varies depending on the use but, in general, is preferably from 0.3 to 3.0 g/m². Within this range, good sensitivity and good film properties of the image recording layer can be obtained.

For the coating, various methods may be used and examples thereof include bar coater coating, rotary coating, spray coating, curtain coating, dip coating, air knife coating, blade coating and roll coating.

### <Support>

The support for use in the lithographic printing plate precursor of the present invention is not particularly limited and may be sufficient if it is a dimensionally stable plate-like material. Examples thereof include paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film laminated or vapor-deposited with the above-described metal. Among these supports, polyester film and aluminum plate are preferred, and aluminum plate is more preferred because this is dimensionally stable and relatively inexpensive.

The aluminum plate is a pure aluminum plate, an alloy plate mainly comprising aluminum and containing trace heteroelements, or an aluminum or aluminum alloy thin film laminated with a plastic. Examples of the heteroelement contained in the aluminum alloy include silicon, iron, manganese, copper, magnesium, chromium, zinc, bismuth, nickel and titanium. The heteroelement content in the alloy is preferably 10 mass% or less. In the present invention, a pure aluminum plate is preferred, but perfectly pure aluminum is difficult to produce in view of refining technique and therefore, an aluminum plate containing trace heteroelements may be used. The aluminum plate is not particularly limited in its composition, and a conventionally known and commonly employed material can be appropriately used.

The thickness of the support is preferably from 0.1 to 0.6 mm, more preferably from 0.15 to 0.4 mm, still more preferably from 0.2 to 0.3 mm.

In advance of using the aluminum plate, the aluminum plate is preferably subjected to a surface treatment such as surface roughening and anodization. By this surface treatment, it is facilitated to enhance hydrophilicity and ensure adhesion between the image recording layer and the support. Before the surface-roughening of aluminum plate, a degreasing treatment for removing the rolling oil on the surface is performed, if desired, by using a surfactant, an organic solvent, an alkaline aqueous solution or the like.

The surface-roughening treatment of the aluminum plate surface is performed by various methods and examples thereof include a mechanical surface-roughening treatment, an electrochemical surface-roughening treatment (surface-roughening treatment of electrochemically dissolving the surface) and a chemical surface-roughening treatment (a surface-roughening treatment of chemically and selectively dissolving the surface).

The mechanical surface-roughening treatment may be performed by using a known method such as ball polishing, brush polishing, blast polishing and buff polishing.

The method for the electrochemical surface-roughening treatment includes, for example, a method of passing an alternating or direct current in an electrolytic solution containing an acid such as hydrochloric acid or nitric acid. Also, a method using a mixed acid described in JP-A-54-63902 may be used.

The surface-roughened aluminum plate is, if desired, subjected to an alkali etching treatment using an aqueous solution of potassium hydroxide, sodium hydroxide or the like and after a neutralization treatment, further subjected to an anodization treatment, if desired, so as to enhance the abrasion resistance.

As for the electrolyte used in the anodization treatment of the aluminum plate, various electrolytes of forming a porous oxide film may be used. In general, sulfuric acid, hydrochloric acid, oxalic acid, chromic acid or a mixed acid thereof is used. The concentration of the electrolyte is determined appropriately in accordance with the kind of the electrolyte.

The anodization treatment conditions vary depending on the electrolyte used and therefore, cannot be indiscriminately specified, but in general, the conditions are preferably such that the concentration of electrolyte is from 1 to 80 mass%, the liquid temperature is from 5 to 70°C, the current density is from 5 to 60 A/dm², the voltage is from 1 to 100 V, and the electrolysis time is from 10 seconds to 5 minutes. The amount of the anodic oxide film formed is preferably from 1.0 to 5.0 g/m², more preferably from 1.5 to 4.0 g/m². Within this range, good press life and good scratch resistance in the non-image area of the lithographic printing plate can be obtained.

With respect to the support for use in the invention, the substrate having thereon an anodic oxide film after the above-described surface treatment may be used as-is, but in order to more improve adhesion to the upper layer, hydrophilicity, antiscumming property, heat insulation and the like, treatments described in JP-A-2001-253181 and JP-A-2001-322365 may be appropriately selected and applied, if desired, such as treatment for enlarging micropores of the anodic oxide film, treatment for pore-sealing micopores and surface-hydrophilizing treatment of dipping the substrate in an aqueous solution containing a hydrophilic compound.

As for the hydrophilization treatment, an alkali metal silicate method described in U.S. Patents 2,714,066, 3,181,461, 3,280,734 and 3,902,734 is known. In this method, the support is dipped in an aqueous solution of sodium silicate or the like, or electrolyzed. Other examples include a method of treating the support with potassium fluorozirconate described in JP-B-36-22063, and a method of treating the support with polyvinylphosphonic acid described in U.S. Patents 3,276,868, 4,153,461 and 4,689,272.

In the case where a support insufficient in surface hydrophilicity, such as polyester film, is used in the present invention, a hydrophilic layer is preferably coated to render the surface hydrophilic. Preferred examples of the hydrophilic layer include a hydrophilic layer formed by coating a coating solution containing a colloid of an oxide or hydroxide of at least one element selected from beryllium, magnesium, aluminum, silicon, titanium, boron, germanium, tin, zirconium, iron, vanadium, antimony and transition metals described in JP-A-2001-199175, a hydrophilic layer having an organic hydrophilic matrix obtained by crosslinking or pseudo-crosslinking an organic hydrophilic polymer described in JP-A-2002-79772, a hydrophilic layer having an inorganic hydrophilic matrix obtained by sol-gel conversion comprising hydrolysis and condensation of polyalkoxysilane, titanate, zirconate or aluminate, and a hydrophilic layer comprising an inorganic thin film having a surface containing a metal oxide. Among these, a hydrophilic layer formed by coating a coating solution containing a colloid of oxide or hydroxide of silicon is more preferred.

In the case of using a polyester film or the like for the support of the present invention, an antistatic layer is preferably provided on the hydrophilic layer side or opposite side of the support or on both sides. When an antistatic layer is provided between the support and the hydrophilic layer, this contributes also to the enhancement of adhesion to the hydrophilic layer. Examples of the antistatic layer which can be used include a polymer layer having dispersed therein metal oxide fine particle or matting agent described in JP-A-2002-79772.

The support preferably has a center line average roughness of 0.10 to 1.2 µm. Within this range, good adhesion to the image recording layer, good press life and good antiscumming property can be obtained.

The color density of the support is preferably from 0.15 to 0.65 in terms of the reflection density value. Within this range, good image-forming property by virtue of antihalation at the image exposure and good suitability for plate inspection after development can be obtained.

### <Undercoat Layer>

In the lithographic printing plate precursor of the present invention, an undercoat layer comprising a compound having a polymerizable group is preferably provided on the support. When the undercoat layer is used, the image recording layer is provided on the undercoat layer. By virtue of the undercoat layer, in the exposed area, adhesion between the support and the image recording layer is strengthened, whereas in the unexposed area, separation of the image recording layer from the support is facilitated, so that the on-press developability can be enhanced.

Specific suitable examples of the undercoat layer include a silane coupling agent having an addition-polymerizable ethylenic double bond reactive group described in JP-A-10-282679, and a phosphorus compound having an ethylenic double bond reactive group described in JP-A-2-304441. Also, a compound having a polymerizable group such as methacryl group and allyl group, and a support-adsorbing group such as sulfonic acid group, phosphoric acid group and phosphoric acid ester is preferred. Furthermore, a compound obtained by adding a hydrophilicity-imparting group such as ethylene oxide group to the above-described compound is also suitably used.

The coated amount (solid content) of the undercoat layer is preferably from 0.1 to 100 mg/m², more preferably from 1 to 30 mg/m².

### <Backcoat Layer>

After the support is surface-treated or the undercoat layer is formed, a backcoat may be provided on the back surface of the support, if desired.

Suitable examples of the backcoat include a coat layer comprising a metal oxide obtained by hydrolyzing and polycondensing an organic polymer compound described in JP-A-5-45885 or an organic or inorganic metal compound described in JP-A-6-35174. In particular, those using an alkoxy compound of silicon, such as Si(OCH₃)₄, Si(OC₂H₅)₄, Si(OC₃H₇)₄ and Si(OC₄H₉)₄, are preferred because the raw material is inexpensive and easily available.

### <Protective Layer>

In the lithographic printing plate precursor of the present invention for use in the lithographic printing method of the present invention, the image formation is hardly affected by oxygen upon exposure and a protective layer for blocking oxygen is not necessarily required, but for the purpose of preventing generation of scratches or the like on the image recording layer, preventing ablation at the exposure with a high-intensity laser or blocking oxygen to more enhance the image strength, a protective layer may be provided on the image recording layer, if desired.

In the present invention, the exposure is usually performed in air and the protective layer prevents low molecular compounds such as oxygen and basic substance, which are present in air and inhibit an image-forming reaction occurring upon exposure in the image recording layer, from mixing into the image recording layer and thereby prevents the inhibition of image-forming reaction at the exposure in air. Accordingly, the property required of the protective layer is low permeability to low molecular compounds such as oxygen. Furthermore, the protective layer preferably has good transparency to light used for exposure, excellent adhesion to the image recording layer, and easy removability during on-press development after exposure. Various studies have been heretofore made on the protective layer having these properties and such protective layers are described in detail, for example, in U.S. patent 3,458,311 and JP-B-55-49729.

Examples of the material used for the protective layer include water-soluble polymer compounds having relatively excellent crystallinity. Specific examples thereof include water-soluble polymers such as polyvinyl alcohol, polyvinylpyrrolidone, acidic celluloses, gelatin, gum arabic and polyacrylic acid.

In particular, when polyvinyl alcohol (PVA) is used as the main component, most excellent results are obtained with respect to basic properties such as oxygen-blocking property and development removability. A part of the polyvinyl alcohol may be replaced by an ester, an ether or an acetal or may have another copolymerization component as long as it contains an unsubstituted vinyl alcohol unit for giving necessary oxygen-blocking property and water solubility to the protective layer.

Examples of the polyvinyl alcohol which can be suitably used include those having a hydrolysis degree of 71 to 100% and a polymerization degree of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (for example, selection of PVA and use of additives), coated amount and the like of the protective layer are appropriately selected by taking account of fogging, adhesion, scratch resistance and the like in addition to the oxygen-blocking property and development removability. In general, as the PVA has a higher percentage of hydrolysis (namely, as the unsubstituted vinyl alcohol unit content in the protective layer is higher) or as the layer thickness is larger, the oxygen-blocking property is elevated and this is preferred in view of sensitivity. Also, in order to prevent the generation of unnecessary polymerization reaction during production or storage or unnecessary fogging, thickening of image line or the like at the image exposure, excessively high oxygen permeability is not preferred. Accordingly, the oxygen permeability A at 25°C and 1 atm is preferably 0.2≤A≤20 (cc/m²·day).

As for other components of the protective layer, glycerin, dipropylene glycol or the like may be added in an amount corresponding to several mass% based on the (co)polymer to impart flexibility. Also, an anionic surfactant such as sodium alkylsulfate and sodium alkylsulfonate; an amphoteric surfactant such as alkylaminocarboxylate and alkylaminodicarboxylate; or a nonionic surfactant such as polyoxyethylene alkylphenyl ether may be added in an amount of several mass% based on the (co)polymer.

The adhesion to the image area, scratch resistance and the like of the protective layer are also very important in view of handling of the lithographic printing plate precursor. More specifically, when a protective layer which is hydrophilic by containing a water-soluble polymer compound is stacked on the image recording layer which is lipophilic, the protective layer is readily separated due to insufficient adhesive strength and in the separated portion, defects such as curing failure ascribable to polymerization inhibition by oxygen may be caused.

In order to solve this problem, various proposals have been made with an attempt to improve the adhesive property between the image recording layer and the protective layer. For example, JP-A-49-70702 and Unexamined British Patent Publication No. 1,303,578 describe a technique of mixing from 20 to 60 mass% of an acrylic emulsion, a water-insoluble vinylpyrrolidone-vinyl acetate copolymer or the like in a hydrophilic polymer mainly comprising polyvinyl alcohol, and stacking the obtained polymer mixture on the image recording layer, thereby providing sufficiently high adhesive property. In the present invention, these known techniques all can be used.

Furthermore, other functions may be imparted to the protective layer. For example, when a colorant (for example, water-soluble dye) excellent in the transparency to light used for exposure and capable of efficiently absorbing light at other wavelengths is added, the aptitude for safelight can be enhanced without causing decrease of sensitivity.

The thickness of the protective layer is suitably from 0.1 to 5 µm, preferably from 0.2 to 2 µm.

The method for coating the protective layer is described in detail, for example, in U.S. Patent 3,458,311 and JP-B-55-49729.

### <Lithographic Printing Method>

In the lithographic printing method using the lithographic printing plate precursor of the present invention, the lithographic printing plate precursor of the present invention is imagewise exposed by exposure through a transparent original having a line image, a halftone image or the like or by laser scanning exposure based on digital data. Examples of the light source for exposure include a carbon arc lamp, a high-pressure mercury lamp, a xenon lamp, a metal halide lamp, a fluorescent lamp, a tungsten lamp, a halogen lamp, an ultraviolet laser, a visible light laser and an infrared laser. In particular, a laser is preferred and examples thereof include a semiconductor laser of emitting light at 250 to 420 nm and a solid or semiconductor laser of emitting infrared ray at 760 to 1,200 nm. In the case of using a laser, the exposure is preferably performed by imagewise scanning the laser based on digital data. Also, in order to shorten the exposure time, a multi-beam laser device is preferably used.

In the case of using a laser, the exposure time is preferably 20 µ seconds or less per one picture element.

In the present invention, the lithographic printing plate precursor of the present invention after imagewise exposure as above is heat-treated, if desired, so as to impart white light safety, and with or without passing through development, used for printing by supplying an oily ink and an aqueous component.

### <Development Processing>

In the case of applying a development processing with a developer, the developer may be a conventionally known aqueous alkali solution. Examples thereof include an inorganic alkali agent such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium bicarbonate, potassium bicarbonate, ammonium bicarbonate, sodium borate, potassium borate, ammonium borate, sodium hydroxide, ammonium hydroxide, potassium hydroxide and lithium hydroxide. In addition, an organic alkali agent such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine may also be used.

These alkali agents are used individually or in combination of two or more thereof. Among these aqueous alkali solutions, the developer of more successfully bringing out the effect of the present invention is an alkali metal silicate-containing aqueous solution at a pH of 12 or more. The developability of the aqueous alkali metal silicate solution can be controlled by the ratio (generally denoted by the molar ratio of [SiO₂]/[M₂O] between silicon oxide SiO₂ as a silicate component and alkali metal oxide M₂O, and the concentration. For example, an aqueous sodium silicate solution disclosed in JP-A-54-62004 in which the SiO₂/Na₂O molar ratio is from 1.0 to 1.5 (that is, [SiO₂]/[Na₂O] is from 1.0 to 1.5) and the SiO₂ content is from 1 to 4 mass%, or an aqueous alkali metal silicate solution described in JP-B-57-7427 in which [SiO₂]/[M] is from 0.5 to 0.75 (that is, [SiO₂]/[M₂O] is from 1.0 to 1.5) and the SiO₂ concentration is from 1 to 4 mass% and which contains at least 20 mass% of potassium based on the gram atom of all alkali metals present in the developer, is suitably used. The pH of the developer is preferably from 9 to 13.5, more preferably from 10 to 13, the developer temperature is preferably from 15 to 40°C, more preferably from 20 to 35°C, and the development time is preferably from 5 to 60 seconds, more preferably from 7 to 40 seconds.

Furthermore, in the case of developing the photosensitive lithographic printing plate by using an automatic developing machine, it is known that when an aqueous solution (replenisher) having an alkali intensity higher than that of developer is added to the developer, a large number of photosensitive lithographic printing plates can be processed without exchanging the developer in the developing tank for a long period of time. Also in the present invention, this replenishing system is preferably used. The method suitably used therefor is, for example, a method disclosed in JP-A-54-62004 where the developer used is an aqueous sodium silicate solution in which the SiO₂/Na₂O molar ratio is from 1.0 to 1.5 (that is, [SiO₂]/[Na₂O] is from 1.0 to 1.5) and the SiO₂ content is from 1 to 4 mass%, and an aqueous sodium silicate solution (replenisher) in which the SiO₂/Na₂O molar ratio is from 0.5 to 1.5 (that is, [SiO₂]/[Na₂O] is from 0.5 to 1.5) is added to the developer continuously or intermittently according to the number of lithographic printing plate precursors processed, or a development method described in JP-B-57-7427 where the developer used is an aqueous alkali metal silicate solution in which [SiO₂]/[M] is from 0.5 to 0.75 (that is, [SiO₂]/[M₂O] is from 1.0 to 1.5) and the SiO₂ concentration is from 1 to 4 mass%, the replenisher used is an alkali metal silicate solution in which [SiO₂]/[M] is from 0.25 to 0.75 (that is, [SiO₂]/[M₂O] is from 0.5 to 1.5), and the developer and the replenisher both contain at least 20 mass% of potassium based on the gram atom of all alkali metals present therein.

The photosensitive lithographic printing plate after such development processing is after-treated with washing water, a rinsing solution containing a surfactant and the like, and a desensitizing solution containing gum arabic, a starch derivative and the like as described, for example, in JP-A-54-8002, JP-A-55-115045 and JP-A-59-58431. For the after-treatment of the photosensitive lithographic printing plate of the present invention, these treatments can be used in various combinations. The lithographic printing plate obtained through such treatments is loaded on an offset printing press and used for printing a large number of sheet. As for the plate cleaner used to remove scumming on the plate at printing, a conventionally known plate cleaner for PS plates is used and examples thereof include CL-1, CL-2, CP, CN-4, CN, CG-1, PC-1, SR and IC (produced by Fuji Photo Film Co., Ltd.).

In the plate-making process of the lithographic printing plate precursor for use in the plate-making method of the present invention, it is also effective for enhancing the image strength and press life to apply after-heating or exposure to the entire surface of the image after development. For the heating after development, a very strong condition is employed. This heating is usually performed at 200 to 500°C. If the heating temperature is low, a satisfactory image-strengthening effect cannot be obtained, whereas if it is too high, problems such as deterioration of support or thermal decomposition of image area are caused.

### <On-Press Development Processing>

Specific examples of the method of performing printing without passing through development include a method where the lithographic printing plate precursor is exposed, loaded on a printing press without passing through development and used for printing, and a method where the lithographic printing plate is loaded on a printing press, exposed on the printing press and used as-is for printing.

In the image recording layer of the imagewise exposed lithographic printing plate precursor, the exposed area is cured by polymerization and becomes insoluble. When this exposed lithographic printing plate precursor is used for printing by supplying an oily ink and an aqueous component without passing through development such as wet development, the uncured image recording layer in the unexposed area is dissolved or dispersed with the oily ink and/or aqueous component and removed and the hydrophilic support surface in that portion is revealed, whereas the polymerized and cured image recording layer in the exposed area remains to form an oily ink-receiving part (image area) having a lipophilic surface.

As a result, the aqueous component adheres to the revealed hydrophilic surface and the oily ink lands on the image recording layer in the exposed region, whereby printing starts. Here, either the aqueous component or the oily ink may be first supplied to the plate surface, but the oily ink is preferably first supplied so as to prevent the aqueous component from being contaminated by the image-recording layer in the unexposed area. A fountain solution and a printing ink for normal lithographic printing are used as the aqueous component and the oily ink, respectively.

In this way, the lithographic printing plate precursor is on-press developed on an offset printing press and used as-is for printing a large number of sheets.

### [Examples]

The present invention is described in greater detail below by referring to the Examples, but the present invention should not be construed as being limited thereto.

### 1. Preparation of Support

A 0.3 mm-thick aluminum plate (construction material: 1050) was degreased with an aqueous 10 mass% sodium aluminate solution at 50°C for 30 seconds to remove the rolling oil on the surface. Thereafter, the aluminum plate surface was grained by using three nylon brushes implanted with bundled bristles having a diameter of 0.3 mm and a water suspension (specific gravity: 1.1 g/cm³) of pumice having a median diameter of 25 µm, and then thoroughly washed with water. This plate was etched by dipping it in an aqueous 25 mass% sodium hydroxide solution at 45°C for 9 seconds and after washing with water, dipped in 20 mass% nitric acid at 60°C for 20 seconds, followed by washing with water. At this time, the etched amount of the grained surface was about 3 g/m².

Subsequently, the aluminum plate was subjected to a continuous electrochemical surface-roughening treatment by using AC voltage at 60 Hz. The electrolytic solution used here was an aqueous 1 mass% nitric acid solution (containing 0.5 mass% of aluminum ion) at a liquid temperature of 50°C. This electrochemical surface-roughening treatment was performed by using an AC power source of giving a rectangular AC having a trapezoidal waveform such that the time TP necessary for the current value to reach the peak from zero was 0.8 msec and the duty ratio was 1:1, and disposing a carbon electrode as the counter electrode. The auxiliary anode was ferrite. The current density was 30 A/dm² in terms of the peak value of current, and 5% of the current flowing from the power source was split to the auxiliary anode. The quantity of electricity at the nitric acid electrolysis was 175 C/dm² when the aluminum plate was serving as the anode. Thereafter, the aluminum plate was water-washed by spraying.

Thereafter, the aluminum plate was subjected to an electrochemical surface-roughening treatment in the same manner as in the nitric acid electrolysis above by using, as the electrolytic solution, an aqueous 0.5 mass% hydrochloric acid solution (containing 0.5 mass% of aluminum ion) at a liquid temperature of 50°C under the conditions that the quantity of electricity was 50 C/dm² when the aluminum plate was serving as the anode, and then water-washed by spraying. This plate was treated in 15 mass% sulfuric acid (containing 0.5 mass% of aluminum ion) as the electrolytic solution at a current density of 15 A/dm² to provide a DC anodic oxide film of 2.5 g/m², then washed with water and dried.

Subsequently, the plate was subjected to pore-sealing treatment by exposing it to a saturated water vapor atmosphere at 100°C for 10 seconds, and then treated in an aqueous 2.5 mass% sodium silicate solution at 30°C for 10 seconds.

Furthermore, the following Undercoat Solution (1) was coated to have a dry coated mass of 5 mg/m², thereby preparing Supports (A) to (D) for use in tests.

**Undercoat Solution (1):**

| | |
|---|---|
| Undercoat Compound (1) shown below | 0.017 g |
| Methanol | 9.00 g |
| Water | 1.00 g |

### Undercoat Compound (1):

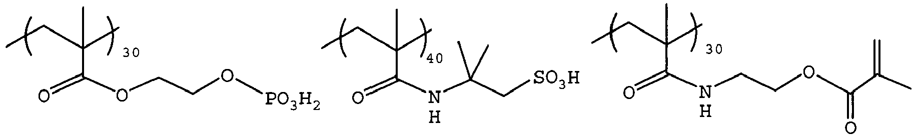

The center line average roughness (Ra) on the surface of the obtained support was measured by using a needle having a diameter of 2 µm and found to be 0.51 µm. 2. Production of Lithographic Printing Plate Precursor

### [Production of Lithographic Printing Plate Precursor (1) (photopolymer plate material)]

On the support subjected to undercoating above, Coating Solution (1) for Image Recording Layer having the following composition was coated to have a dry coated mass of 1.5 g/m² and dried at 100°C for 1 minute to form an image recording layer. Further thereon, Coating Solution (1) for Protective Layer was coated to have a dry coated mass of 2.5 g/m² and dried at 120°C for 1 minute to obtain Lithographic Printing Plate Precursor (1).

**<Coating Solution (1) for Image Recording Layer>**

| | |
|---|---|
| Tetramethylolmethane tetraacrylate | 20 g |
| Binder Polymer (1) shown below (average molecular weight: 50,000) | 30 g |
| Polymerization Initiator (1) shown below | 1 g |
| Sensitizing Dye (1) | 0.5 g |
| Polymerization inhibitor precursor (Compound I-17) | 1 g |
| Dispersion of ε-Phthalocyanine/Binder Polymer (1) | 2 g |
| Fluorine-containing surfactant Megafac F177 (produced Dai-Nippon Ink & Chemicals, Inc.) | 0.5 g |
| Methyl ethyl ketone | 200 g |
| Propylene glycol monomethyl ether acetate | 200 g |

### Binder Polymer (1):

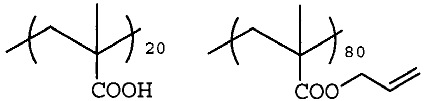

### Polymerization Initiator (1):

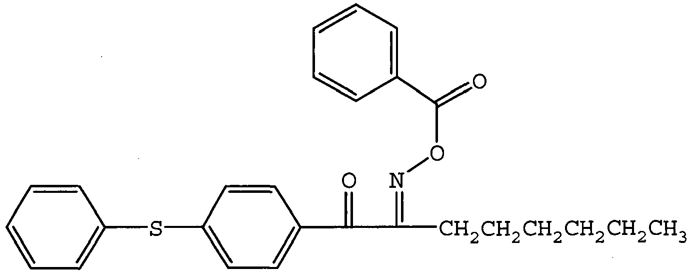

### Sensitizer (1):

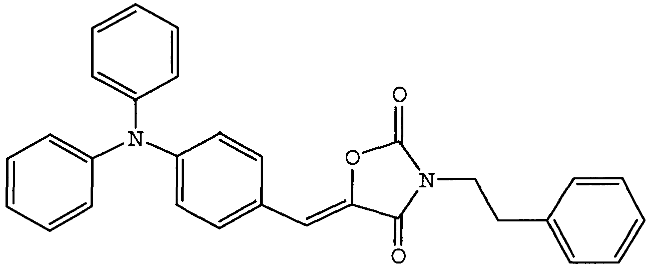

**<Coating Solution (1) for Protective Layer>**

| | |
|---|---|
| Polyvinyl alcohol (saponification degree: 95 mol%, polymerization degree: 800) | 40 g |
| Polyvinylpyrrolidone (molecular weight: 50,000) | 5 g |
| Poly(vinylpyrrolidone/vinyl acetate (1/1)), molecular weight: 70,000 | 5 g |
| Water | 950 g |

### [Production of Lithographic Printing Plate Precursor (2) (on-press development plate material)]

Coating Solution (2) for Image Recording Layer having the following composition was bar-coated on the support subjected to undercoating above, and dried in an oven at 70°C for 60 seconds to form an image recording layer having a dry coated mass of 1.0 g/m², and Coating Solution (1) for Protective Layer was coated thereon to have a dry coated mass of 0.5 g/m² and dried at 120°C for 1 minute to obtain Lithographic Printing Plate Precursor (2).

**<Coating Solution (2) for Image Recording Layer>**

| | |
|---|---|
| Polymerization Initiator (1) | 0.2 g |
| Sensitizing Dye (1) | 0.1 g |
| Polymerization inhibitor precursor (Compound I-17) | 0.5 g |
| Binder Polymer (2) shown below (average molecular weight: 80,000) | 6.0 g |
| Polymerizable compound: isocyanuric acid EO-modified triacrylate (Aronics M-315, produced by Toa Gosei Co., Ltd.) | 12.4 g |
| Leuco Crystal Violet | 0.5 g |
| Tetraethylammonium chloride | 0.1 g |
| Fluorine-Containing Surfactant (1) shown below | 0.1 g |
| Methyl ethyl ketone | 70.0 g |

### Binder Polymer (2):

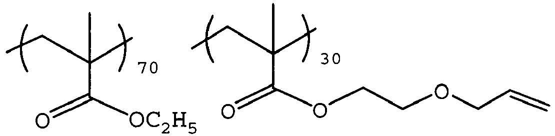

### Fluorine-Containing Surfactant (1):

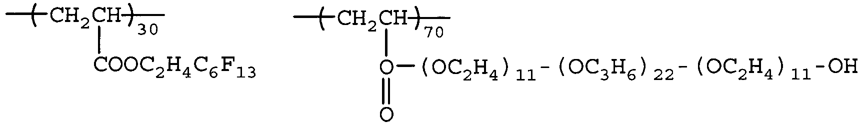

### [Production of Lithographic Printing Plate Precursor (3) (microcapsule-type on-press development plate material)]

Lithographic Printing Plate Precursor (3) was obtained in the same manner as Lithographic Printing Plate Precursor (2) except for changing Coating Solution (2) for Image Recording Layer to Coating Solution (3) for Image Recording Layer having the following composition.

**<Coating Solution (3) for Image Recording Layer>**

| | |
|---|---|
| Polymerization Initiator (1) | 0.2 g |
| Sensitizing Dye (1) | 0.1 g |
| Polymerization inhibitor precursor (Compound I-17) | 0.5 g |
| Binder Polymer (2) (average molecular weight: 80,000) | 3.0 g |
| Polymerizable compound: isocyanuric acid EO-modified triacrylate (Aronics M-315, produced by Toa Gosei Co., Ltd.) | 6.2 g |
| Leuco Crystal Violet | 0.5 g |
| Fluorine-Containing Surfactant (1) | 0.1 g |
| Microcapsule (1) shown below (as solid content) | 10.0 g |
| Methyl ethyl ketone | 35.0 g |
| 1-Methoxy-2-propanol | 35.0 g |
| Water | 10.0 g |

### (Synthesis of Microcapsule (1))

As the oil phase component, 10 g of trimethylolpropane and xylene diisocyanate adduct (Takenate D-110N, produced by Mitsui Takeda Chemicals, Inc.), 4.15 g of isocyanuric acid EO-modified diacrylate (Aronics M-215, produced by Toa Gosei Co., Ltd.) and 0.1 g of Pionin A-41C (produced by Takemoto Yushi Co., Ltd.) were dissolved in 17g of ethyl acetate. As the aqueous phase component, 40 g of an aqueous 4 mass% PVA-205 solution was prepared. The oil phase component and the aqueous phase component were mixed and emulsified in a homogenizer at 12,000 rpm for 10 minutes. The resulting emulsified product was added to 25 g of distilled water and the obtained mixture was stirred at room temperature for 30 minutes and then stirred at 40°C for 3 hours. The thus-obtained Microcapsule Solution (1) was diluted with distilled water to a solid content concentration of 20 mass%. The average particle diameter was 0.25 µm.

### [Production of Lithographic Printing Plate Precursor (4) (Comparison of Lithographic Printing Plate Precursor (2))]

Lithographic Printing Plate Precursor (4) was obtained in the same manner as Lithographic Printing Plate Precursor (2) except for not adding the polymerization inhibitor (Compound I-17) to Coating Solution (2) for Image Recording Layer.

### [Production of Lithographic Printing Plate Precursor (5) (Comparison of Lithographic Printing Plate Precursor (2))]

Lithographic Printing Plate Precursor (5) was obtained in the same manner as Lithographic Printing Plate Precursor (2) except for changing 0.5 g of the polymerization inhibitor (Compound I-17) of Coating Solution (2) for Image Recording Layer to 0.36 g of Polymerization Inhibitor (1) shown below.

### Polymerization Inhibitor (1):

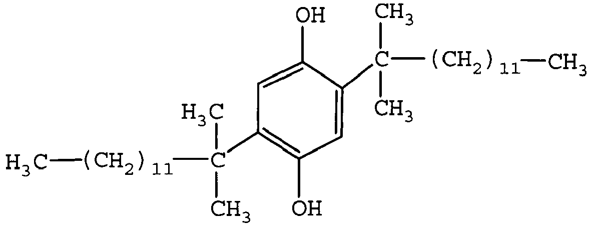

### [Production of Lithographic Printing Plate Precursor (6) (on-press development plate material, change of initiation system)]

Lithographic Printing Plate Precursor (6) was obtained in the same manner as Lithographic Printing Plate Precursor (2) except for changing Polymerization Initiator (1) of Coating Solution (2) for Image Recording Layer to Polymerization Initiator (2) shown below and changing Sensitizing Dye (1) to Sensitizing Dye (2) shown below.

### Polymerization Initiator (2):

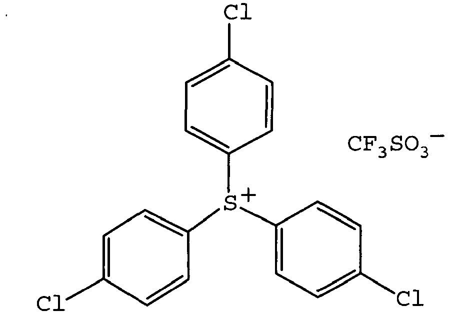

### Sensitizing Dye (2):

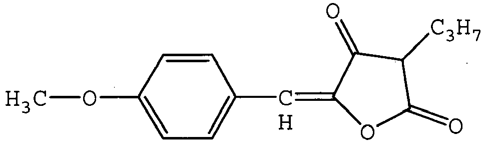

### [Production of Lithographic Printing Plate Precursor (7) (on-press development plate material, change of initiation system)]

Lithographic Printing Plate Precursor (7) was obtained in the same manner as Lithographic Printing Plate Precursor (2) except for changing Polymerization Initiator (1) of Coating Solution (2) for Image Recording Layer to Polymerization Initiator (3) shown below and not adding Sensitizing Dye (1).

### Polymerization Initiator (3):

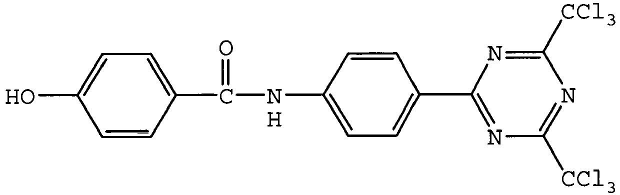

### [Production of Lithographic Printing Plate Precursor (8) (on-press development plate material, change of initiation system)]

Lithographic Printing Plate Precursor (8) was obtained in the same manner as Lithographic Printing Plate Precursor (2) except for changing Coating Solution (2) for Image Recording Layer to the following Coating solution (4) for Image Recording Layer.

**Coating Solution (4) for Image Recording Layer:**

| | |
|---|---|
| Infrared Absorbent (1) shown below | 0.05 g |
| Polymerization Initiator (4) shown below | 0.20 g |
| Polymerization inhibitor precursor (Compound I-17) | 0.10 g |
| Binder Polymer (2) | 0.50 g |
| Polymerizable monomer, Aronics M-215 (produced by Toa Gosei Co., Ltd.) | 1.00 g |
| Naphthalenesulfonate of Victoria Pure Blue | 0.02 g |
| Fluorine-Containing Surfactant (1) | 0.10 g |
| Methyl ethyl ketone | 18.0 g |

### Infrared Absorbent (1):

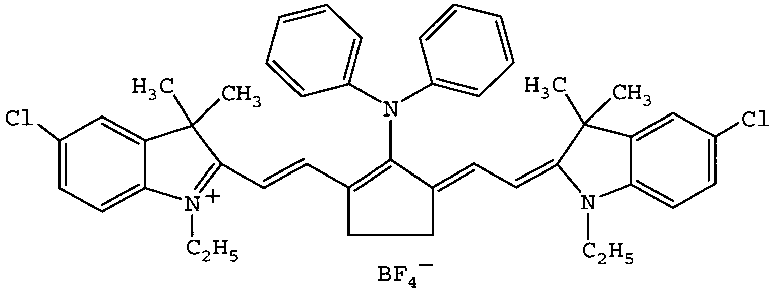

### Polymerization Initiator (4):

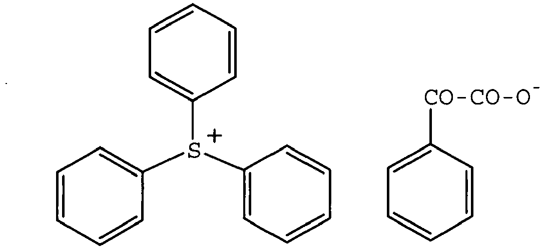

### [Production of Lithographic Printing Plate Precursor (9) (microcapsule-type on-press development plate material, change of initiation system)]

Lithographic Printing Plate Precursor (9) was obtained in the same manner as Lithographic Printing Plate Precursor (3) except for changing Coating Solution (3) for Image Recording Layer to the following Coating solution (5) for Image Recording Layer.

### Coating Solution (5) for Image Recording Layer:

Coating Solution (5) for Image Recording Layer was obtained by mixing and stirring the following Photosensitive Solution (1) and Microcapsule Solution (2) immediately before coating.

**Photosensitive Solution (1):**

| | |
|---|---|
| Binder Polymer (3) shown below | 0.162 g |
| Polymerization Initiator (4) | 0.100 g |
| Infrared Absorbent (2) shown below | 0.020 g |
| Polymerization inhibitor precursor (Compound I-17) | 0.05 g |
| Polymerizable compound (Aronics M-215, produced by Toa Gosei Co., Ltd.) | 0.385 g |
| Fluorine-Containing Surfactant (1) | 0.044 g |
| Methyl ethyl ketone | 1.091 g |
| 1-Methoxy-2-propanol | 8.609 g |

**Microcapsule Solution (2):**

| | |
|---|---|
| Microcapsule (2) synthesized as follows | 2.640 g |
| Water | 2.425 g |

### Infrared Absorbent (2):

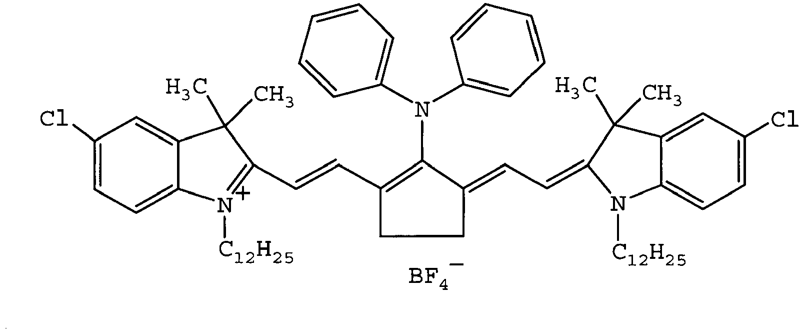

### Binder Polymer (3):

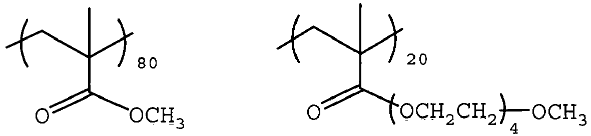

### (Synthesis of Microcapsule (2))

As the oil phase component, 10 g of trimethylolpropane and xylene diisocyanate adduct (Takenate D-110N, produced by Mitsui Takeda Chemicals, Inc.), 3.15 g of pentaerythritol triacrylate (SR444, produced by Nippon Kayaku Co., Ltd.), 0.35 g of Infrared Absorbent (2), 1 g of 3-(N,N-diethylamino)-6-methyl-7-anilinofluorane (ODB, produced by Yamamoto Chemicals, Inc.), and 0.1 g of Pionin A-41C (produced by Takemoto Yushi Co., Ltd.) were dissolved in 17 g of ethyl acetate. As the aqueous phase component, 40 g of an aqueous 4 mass% PVA-205 solution was prepared. The oil phase component and the aqueous phase component were mixed and emulsified in a homogenizer at 12,000 rpm for 10 minutes. The resulting emulsified product was added to 25 g of distilled water and the obtained mixture was stirred at room temperature for 30 minutes and then stirred at 40°C for 3 hours. The thus-obtained microcapsule solution was diluted with distilled water to a solid content concentration of 15 mass%. The average particle diameter was 0.2 µm.

### [Production of Lithographic Printing Plate Precursors (10) to (13) (on-press development plate material, change of polymerization inhibitor precursor)]

Lithographic Printing Plate Precursors (10) to (13) were obtained in the same manner as Lithographic Printing Plate Precursor (2) except for changing the polymerization inhibitor precursor Compound I-17 of Coating Solution (2) for Image Recording Layer to polymerization inhibitor precursor Compounds I-5, I-6, I-7 and I-8, respectively.

### [Production of Lithographic Printing Plate Precursor (14) (on-press development plate material, no protective layer)]

Lithographic Printing Plate Precursor (14) was obtained in the same manner as Lithographic Printing Plate Precursor (2) except for not providing a protective layer on the image recording layer.

### [Production of Lithographic Printing Plate Precursor (15) (on-press development plate material, no protective layer)]

Lithographic Printing Plate Precursor (15) was obtained in the same manner as Lithographic Printing Plate Precursor (8) except for not providing a protective layer on the image recording layer.

### 3. Image Exposure Method

### <Exposure of Lithographic Printing Plate Precursors (1) to (7) and (10) to (14)>

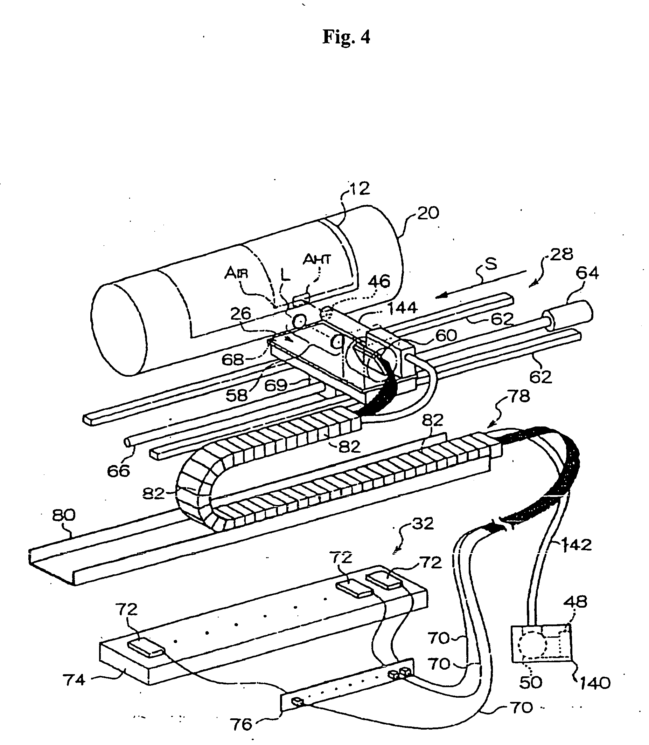

The lithographic printing plate precursor was exposed by a semiconductor laser having an oscillation wavelength of 405 nm (Lithographic Printing Plate Precursors (1) to (5) and (10) to (14)) or 375 nm (Lithographic Printing Plate Precursors (6) and (7)) with use of an exposure head comprising an optical system using a DMD spatial modulation device shown in Fig. 4, under the conditions such that the output was 2 mW, the circumferential length of outer drum was 900 mm, the rotation number of drum was 800 rpm, the resolution was 2,400 dpi and the drawing time for one picture element was 0.9 µsec.

### <Exposure of Lithographic Printing Plate Precursors (8), (9) and (15)>

The lithographic printing plate precursor was exposed by Trendsetter 3244VX (manufactured by Creo) having mounted thereon a water-cooling 40 W infrared (830 nm) semiconductor laser under the conditions such that the output was 9 W, the rotation number of outer drum was 210 rpm and the resolution was 2,400 dpi.

### 4. Heat-Treating Method

The lithographic printing plate precursor after image exposure was placed in an oven, heated by blowing hot air and kept at 140°C for 100 seconds.

### 5. Development Processing

### <Development Processing of Lithographic Printing Plate Precursor (1)>

The printing plate precursor after image exposure and heat treatment was developed at 30°C for 15 seconds by dipping it in a developer DP-4 (produced by Fuji Photo Film Co., Ltd.) 18-fold diluted with water. Thereafter, the plate surface was treated with a gumming solution GU-7 (produced by Fuji Photo Film Co., Ltd.) 2-fold diluted with water.

### <Development Processing of Lithographic Printing Plate Precursors (2) to (15)>

As described in Printing Method below, the printing plate precursor after image exposure and heat treatment was loaded on a printing press without passing through a development processing and developed on the press.

### 6. Printing Method

Lithographic Printing Plate Precursor (1) was, after image exposure, heat treatment and development of the printing plate precursor, was loaded on a printing press SOR-M manufactured by Heidelberg, and then printing was performed at a printing speed of 6,000 sheets/hour by using a fountain solution (EU-3 (etching solution produced by Fuji Photo Film Co., Ltd.)/water/isopropyl alcohol = 1/89/10 (by volume)) and a black ink TRANS-G(N) (produced by Dai-Nippon Ink & Chemicals, Inc.).

Lithographic Printing Plate Precursors (2) to (13) each was, without developing the printing plate precursor after image exposure and heat treatment, fixed to the cylinder of a printing press SOR-M manufactured by Heidelberg, a fountain solution and an ink were supplied thereto by using a fountain solution (IF201 (etching solution produced by Fuji Photo Film Co., Ltd.)/water = 4/96 (by volume)) and a black ink TRANS-G(N) (produced by Dai-Nippon Ink & Chemicals, Inc.), and then printing was performed at a printing speed of 6,000 sheets/hour.

### 7. Evaluation of White Light Safety of Lithographic Printing Plate Precursor

The unexposed lithographic printing plate precursor was heat-treated by the method described above, placed under a white fluorescent lamp and after setting the conditions to give a light intensity of 400 lux on the surface of the lithographic printing plate precursor, exposed to light. The lithographic printing plate precursor exposed to white light was, after development if required, fixed to the cylinder of a printing press SOR-M manufactured by Heidelberg in the same manner as above and used for printing of 100 sheets. The time period exposed under a white fluorescent lamp, with which exposure time ink staining was not caused, was measured up to 300 minutes. As this time period is longer, the white light safety is better.

### [Example 1]

Lithographic Printing Plate Precursor (1) was subjected to image exposure, heat treatment, development and printing of 1,000 sheets as described above. Then, a good printed matter where the non-image area was free of staining and the image area had a sufficiently high ink density was obtained.

The evaluation result of white light safety is shown in Table 1.

### [Examples 2 to 13 and Comparative Example 1]

Lithographic Printing Plate Precursors (2) to (4) and (6) to (15) each was subjected to image exposure and heat treatment and by loading it on a printing press without passing through development as described above, printing of 100 sheets was performed. At this point, removal of the image recording layer in the unexposed area was completed on the printing press and a printed matter with the non-image area being free of ink staining was obtained. Thereafter, 10,000 sheets were further printed, as a result, a good printed matter where the non-image area was free of staining and the image area had a sufficiently high ink density was obtained.

The evaluation results of white light safety are shown in Table 1.

### [Comparative Example 2]

In the same manner as in Example 2 except for not performing heat treatment, Lithographic Printing Plate Precursor (2) was image-exposed, loaded on a printing press without passing through heat treatment and development, and used for printing of 100 sheets. At this point, removal of the image recording layer in the unexposed area was completed on the printing press and a printed matter with the non-image area being free of ink staining was obtained. Thereafter, 10,000 sheets were further printed, as a result, a good printed matter where the non-image area was free of staining and the image area had a sufficiently high ink density was obtained.

However, the evaluation result of white light safety was bad as shown in Table 1.

### [Comparative Example 3]

Lithographic Printing Plate Precursor (5) was, as described above, image-exposed, heat-treated, loaded on a printing press without passing through development, and used for printing of 100 sheets. At this point, removal of the image recording layer in the unexposed area was completed on the printing press and a printed matter with the non-image are being free of ink staining was obtained. Thereafter, 10,000 sheets were further printed, as a result, the ink density in the image area was decreased after printing of 5,000 sheets despite no staining in the non-image area and a good printed matter was not obtained. The evaluation result of white light safety is shown in Table 1. *Examples 8 and 9 do not form part of the invention and are included for reference only.

**Table 1**

| | Lithographic Printing Plate Precursor | Polymerization Inhibitor Precursor | Protective Layer | Heat Treatment | Wavelength of Image Exposure Laser [nm] | White Light Safety [min] |
|---|---|---|---|---|---|---|
| Example 1 | (1) | 1-17 | formed | done | 405 | 150 |
| Example 2 | (2) | 1-17 | formed | done | 405 | 210 |
| Example 3 | (3) | 1-17 | formed | done | 405 | 240 |
| Example 4 | (6) | 1-17 | formed | done | 375 | 270 |
| Example 5 | (7) | 1-17 | formed | done | 375 | 270 |
| Example 6 | (8) | 1-17 | formed | done | 830 | 300 |
| Example 7 | (9) | 1-17 | formed | done | 830 | 300 |
| Example 8* | (10) | 1-5 | formed | done | 405 | 180 |
| Example 9* | (11) | 1-6 | formed | done | 405 | 180 |
| Example 10 | (12) | 1-7 | formed | done | 405 | 210 |
| Example 11 | (13) | 1-8 | formed | done | 405 | 240 |
| Example 12 | (14) | 1-17 | none | done | 405 | 300 |
| Example 13 | (15) | 1-17 | none | done | 830 | 300 |
| Comparative Example 1 | (4) | none | formed | done | 405 | 10 |
| Comparative Example 2 | (2) | 1-17 | formed | none | 405 | 10 |
| Comparative Example 3 | (5) | none (polymerizatio n inhibitor was added) | formed | done | 405 | 210 |

As apparent from the results above, in the image recording material of the present invention, particularly in the lithographic printing plate precursor which is a suitable usage of the image recording material, the polymerization reaction of the image recording layer can be prevented by the heat treatment after image exposure and good white light safety can be obtained without decreasing the sensitivity of the lithographic printing plate at the image exposure.

According to the present invention, an image recording material ensuring excellent white light safety without decreasing the sensitivity at the image exposure can be provided.

## Claims

1. An image recording material comprising:
(A) a polymerization initiator;
(B) a polymerizable compound; **characterised in that** the image recording material further comprises
(C) a compound capable of generating, when heated, a chemical species capable of inhibiting a polymerization reaction, wherein the compound (C) has a phenolic hydroxyl group protected with a group decomposable under heat.

2. The image recording material as claimed in claim 1, which has photosensitivity in a range from 250 to 420 nm.

3. The image recording material as claimed in claim 1, which further comprises an infrared absorbent.

4. A method for inhibiting a polymerization reaction of an image recording material after imagewise exposure, comprising:
imagewise exposing; and
heat-treating the image recording material as claimed in claim 1.

5. The method for inhibiting a polymerization reaction of an image recording material after imagewise exposure as claimed in claim 4,
wherein a light source for the imagewise exposing is a laser.

6. A lithographic printing plate precursor comprising:
a support; and
an image recording layer comprising an image recording material as claimed in claim 1.

7. The lithographic printing plate precursor as claimed in claim 6,
wherein the image recording layer has photosensitivity in a range from 250 to 420 nm.

8. The lithographic printing plate precursor as claimed in claim 6,
wherein the image recording layer further comprises an infrared absorbent.

9. An on-press development method wherein the image recording layer is removed from the lithographic printing plate precursor as claimed in claim 6 with at least one of a printing ink and a fountain solution.

## Patentansprüche

1. Bildaufzeichnungsmaterial, umfassend:
(A) einen Polymerisationsinitiator;
(B) eine polymerisierbare Verbindung;
**dadurch gekennzeichnet, dass** das Bildaufzeichnungsmaterial ferner umfasst
(C) eine Verbindung, die beim Erwärmen eine chemische Spezies bilden kann, die eine Polymerisationsreaktion inhibieren kann, worin die Verbindung (C) eine phenolische Hydroxylgruppe aufweist, die mit einer Gruppe geschützt ist, die durch Wärme zersetzt werden kann.

2. Bildaufzeichnungsmaterial gemäß Anspruch 1, welches eine Fotoempfindlichkeit im Bereich von 250 bis 420 nm aufweist.

3. Bildaufzeichnungsmaterial gemäß Anspruch 1, welches ferner einen Infrarotabsorber umfasst.

4. Verfahren zum Inhibieren einer Polymerisationsreaktion eines Bildaufzeichnungsmaterials nach der bildweisen Belichtung, umfassend:
bildweises Belichten; und
Wärmebehandeln des wie in Anspruch 1 beanspruchten Bildaufzeichnungsmaterials.

5. Verfahren zum Inhibieren einer Polymerisationsreaktion eines Bildaufzeichnungsmaterials nach der bildweisen Belichtung gemäß Anspruch 4,
worin eine Lichtquelle für die bildweise Belichtung ein Laser ist.

6. Lithographiedruckplattenvorläufer, umfassend:
einen Träger; und
eine Bildaufzeichnungsschicht, die ein Bildaufzeichnungsmaterial umfasst, wie es in Anspruch 1 definiert ist.

7. Lithographiedruckplattenvorläufer gemäß Anspruch 6,
worin die Bildaufzeichnungsschicht eine Fotoempfindlichkeit im Bereich von 250 bis 420 nm aufweist.

8. Lithographiedruckplattenvorläufer gemäß Anspruch 6,
worin die Bildaufzeichnungsschicht ferner einen Infrarotabsorber umfasst.

9. Verfahren zur Entwicklung auf der Presse, worin die Bildaufzeichnungsschicht von dem Lithographiedruckplattenvorläufer gemäß Anspruch 6 mit zumindest einem von einer Drucktinte und einer Anfeuchtlösung entfernt wird.

## Revendications

1. Matériau d'enregistrement d'image comprenant :
(A) un initiateur de polymérisation;
(B) un composé polymérisable; **caractérisé en ce que** le matériau d'enregistrement d'image comprend en outre
(C) un composé capable de générer, lorsqu'il est chauffé, une espèce chimique capable d'inhiber une réaction de polymérisation, dans lequel le composé (C) a un groupe hydroxyle phénolique protégé avec un groupe décomposable sous l'effet de la chaleur.

2. Matériau d'enregistrement d'image selon la revendication 1, qui présente une photosensibilité dans une plage de 250 à 420 nm.

3. Matériau d'enregistrement d'image selon la revendication 1, qui comprend en outre un absorbant d'infrarouge.

4. Procédé pour inhiber une réaction de polymérisation d'un matériau d'enregistrement d'image après exposition selon une image, comprenant
une exposition selon une image; et
un traitement thermique du matériau d'enregistrement d'image selon la revendication 1.

5. Procédé pour inhiber une réaction de polymérisation d'un matériau d'enregistrement d'image après exposition selon une image selon la revendication 4,
dans lequel une source lumineuse pour l'exposition selon une image est un laser.

6. Précurseur de plaque d'impression lithographique comprenant :
un support; et
une couche d'enregistrement d'image comprenant un matériau d'enregistrement d'image selon la revendication 1.

7. Précurseur de plaque d'impression lithographique selon la revendication 6,
dans lequel la couche d'enregistrement d'image présente une photosensibilité dans une plage de 250 à 420 nm.

8. Précurseur de plaque d'impression lithographique selon la revendication 6,
dans lequel la couche d'enregistrement d'image comprend en outre un absorbant d'infrarouge.

9. Procédé de développement sur presse, dans lequel la couche d'enregistrement d'image est retirée du précurseur de plaque d'impression lithographique selon la revendication 6 avec au moins une parmi une encre d'impression et une solution de mouillage.
